(19) Europäisches Patentamt / European Patent Office / Office européen des brevets

(11) EP 2 694 523 B1

(12) **EUROPÄISCHE PATENTSCHRIFT**

(45) Veröffentlichungstag und Bekanntmachung des Hinweises auf die Patenterteilung:
**11.01.2017 Patentblatt 2017/02**

(21) Anmeldenummer: **12707709.7**

(22) Anmeldetag: **07.03.2012**

(51) Int Cl.:
***C07F 15/00*** (2006.01) ***H01L 51/00*** (2006.01)

(86) Internationale Anmeldenummer:
**PCT/EP2012/001017**

(87) Internationale Veröffentlichungsnummer:
**WO 2012/136296 (11.10.2012 Gazette 2012/41)**

(54) **METALLKOMPLEXE**

METAL COMPLEXES

COMPLEXES EN MÉTAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.04.2011 EP 11002802**

(43) Veröffentlichungstag der Anmeldung:
**12.02.2014 Patentblatt 2014/07**

(73) Patentinhaber: **Merck Patent GmbH**
**64293 Darmstadt (DE)**

(72) Erfinder:
- **PAN, Junyou**
  **60320 Frankfurt am Main (DE)**
- **PARHAM, Amir Hossain**
  **65929 Frankfurt am Main (DE)**

(56) Entgegenhaltungen:
**WO-A1-2011/024986 WO-A1-2011/025068**
**WO-A2-00/70655**

EP 2 694 523 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft Metallkomplexe, welche sich für den Einsatz als Emitter in organischen Elektrolumineszenzvorrichtungen eignen.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer. Dies gilt insbesondere für OLEDs, welche im kürzerwelligen Bereich, also grün und insbesondere blau, emittieren.

Gemäß dem Stand der Technik werden in phosphoreszierenden OLEDs als Triplettemitter insbesondere Iridiumkomplexe eingesetzt. Es sind beispielsweise Iridiumkomplexe bekannt, welche als Liganden Imidazophenanthridin-Derivate bzw. Diimidazochinazolin-Derivate enthalten (WO 2007/095118). Diese Komplexe können bei Anwendung in organischen Elektrolumineszenzvorrichtungen, je nach genauer Struktur des Liganden, zu blauer Phosphoreszenz führen. Auch hier sind noch weitere Verbesserungen hinsichtlich Effizienz, Betriebsspannung und Lebensdauer, wünschenswert. Weiterhin besteht hier auch noch Verbesserungsbedarf in Bezug auf die Farbkoordinaten, um tiefblaue Emission erzielen zu können.

WO 00/70655 offenbart organische lichtemittierende Vorrichtungen, in denen die emittierende Schicht eine phosphoreszierende organometallische Iridiumverbindung oder eine phosphoreszierende organometallische Osmiumverbindung enthält.

WO 2011/024968 offenbart eine organische Elektrolumineszenzvorrichtung enthaltend einen Metallkomplex, der mit einer Gruppe $-CR^2R^3-ZR^1$ substituiert ist, wobei Z für einen gesättigten 5- bis 8-gliedrigen Ring steht und der Metallkomplex verschiedene Grundstrukturen aufweisen kann. Dieses Dokument offenbart auch eine Kombination von koordinierendem 5- und 6-Ring sowie eine Verbrückung dieser beiden Strukturen als Ligand (z. B. I-14 auf S. 180).

WO 2011/025068 offenbart Metallkomplexe, in denen zwei 6-Ringe und ein 5-Ring annelliert sind. Verbindungen, in denen drei aromatische Sechsringe anelliert sind, sind nicht offenbart. Dieses Dokument offenbart auch einzelne Verbindungen, die ein Stickstoffatom in para-Position zum Metall aufweisen. Ein technischer Effekt, der mit einem Stickstoffatom in dieser Position verknüpft ist, ist nicht offenbart.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche sich auch für blau phosphoreszierende OLEDs eignen, sowie Emitter, welche verbesserte Eigenschaften in Bezug auf Effizienz, Betriebsspannung, Lebensdauer und/oder Farbkoordinaten zeigen.

Überraschend wurde gefunden, dass die unten näher beschriebenen Metallchelatkomplexe, die einen überbrückten Liganden enthalten, der para zum Kohlenstoffatom, das an das Metall bindet, ein Stickstoffatom enthält, diese Aufgabe lösen und zu Verbesserungen der organischen Elektrolumineszenzvorrichtung führen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

$$[M(L)_n(L')_m]_w^{x+/x-}\,[A]_y^{z-/z+} \quad \text{Formel (1)}$$

wobei die Verbindung der allgemeinen Formel (1) eine Teilstruktur M(L)n der Formel (2) enthält:

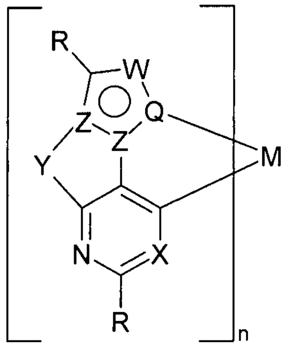

Formel (2)

wobei für die verwendeten Symbole und Indizes gilt:

M ist Iridium;

Q ist bei jedem Auftreten N;

X ist bei jedem Auftreten gleich oder verschieden CR oder N;

Y ist bei jedem Auftreten gleich oder verschieden eine substituierte oder unsubstituierte zweiatomige Brücke enthaltend als Brückenatome zwei Atome, gleich oder verschieden bei jedem Auftreten ausgewählt aus der Gruppe bestehend aus C, N, O, S, Si oder P;

W ist bei jedem Auftreten gleich oder verschieden CR=CR oder CR=N;

Z ist C;

R ist bei jedem Auftreten gleich oder verschieden H, D, F, Cl, Br, I, $N(R^1)_2$, CN, $NO_2$, OH, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^1$ substituiert sein kann, wobei eine oder mehrere nicht benachbarte $CH_2$-Gruppen durch $R^1C=CR^1$, C=C, $Si(R^1)_2$, C=O, $NR^1$, O, S oder $CONR^1$ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 40 aromatischen Ringatomen, die durch einen oder mehrere Reste $R^1$ substituiert sein kann, oder eine Aralkyl- oder Heteroaralkylgruppe mit 5 bis 40 aromatischen Ringatomen, die durch einen oder mehrere Reste $R^1$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^1$ substituiert sein kann; dabei können zwei benachbarte Reste R auch miteinander ein mono- oder polycyclisches, aliphatisches, aromatisches oder heteroaromatisches Ringsystem bilden;

$R^1$ ist bei jedem Auftreten gleich oder verschieden H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, C=O, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 40 aromatischen Ringatomen, die durch einen oder mehrere Reste $R^2$ substituiert sein kann, oder eine Aralkyl- oder Heteroaralkylgruppe mit 5 bis 40 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch

einen oder mehrere Reste $R^2$ substituiert sein kann; dabei können zwei oder mehrere benachbarte Reste $R^2$ miteinander ein mono- oder polycyclisches, aliphatisches Ringsystem bilden;

$R^2$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^2$ auch miteinander ein mono- oder polycyclisches, aliphatisches Ringsystem bilden;

L' ist gleich oder verschieden bei jedem Auftreten ein beliebiger Coligand;

A ist ein Gegenion;

n ist 1, 2 oder 3; m ist O, 1, 2, 3 oder 4;

w ist 1, 2 oder 3;

x, y, z sind bei jedem Auftreten gleich oder verschieden 0, 1, 2 oder 3; dabei gilt, dass $(w \cdot x) = (y \cdot z)$;

dabei können auch mehrere Liganden L miteinander oder L mit L' über eine beliebige Brücke V verknüpft sein und so ein tridentates, tetradentates, pentadentates oder hexadentates Ligandensystem aufspannen;
weiterhin kann auch ein Substituent R zusätzlich an das Metall koordinieren.

Überraschend wurde gefunden, dass in der Teilstruktur der Formel (2) die Anwesenheit des Stickstoffatoms in dem Sechsring in para-Position zur Koordination an das Iridium erfindungswesentlich ist. Gegenüber analogen Komplexen, die an dieser Position statt des Stickstoffatoms ein Kohlenstoffatom aufweisen, zeigen die erfindungsgemäßen Komplexe ein wesentlich höheres Triplettniveau, so dass die Emissionsfarbe deutlich blau verschoben ist.

Der in den Fünfring eingezeichnete Kreis deutet, wie allgemein in der organischen Chemie üblich, einen aromatischen bzw. heteroaromatischen Cyclus mit 6 $\pi$-Elektronen an.

Das Gegenion A ist weist die entgegengesetzte Ladung zum Komplex [M(L)n(L')m] auf.

Dabei werden in den Komplexen der Formel (1) die Indizes n und m so gewählt, dass die Koordinationszahl am Metall M insgesamt, je nach Metall, der für dieses Metall üblichen Koordinationszahl entspricht. Dies ist für Übergangsmetalle je nach Metall üblicherweise die Koordinationszahl 4, 5 oder 6. Es ist generell bekannt, dass Metallkoordinationsverbindungen abhängig vom Metall und von der Oxidationsstufe des Metalls unterschiedliche Koordinationszahlen aufweisen, also eine unterschiedliche Anzahl von Liganden binden. Da die bevorzugten Koordinationszahlen von Metallen bzw. Metallionen in verschiedenen Oxidationsstufen zum allgemeinen Fachwissen des Fachmanns auf dem Gebiet der metallorganischen Chemie bzw. der Koordinationschemie gehören, ist es für den Fachmann ein Leichtes, je nach Metall und dessen Oxidationsstufe und je nach genauer Struktur des Liganden L eine geeignete Anzahl Liganden zu verwenden und somit die Indizes n und m geeignet zu wählen.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, neo-Hexyl, Cyclo-hexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer $C_1$- bis $C_{40}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Wenn die Verbindungen gemäß Formel (1) in einer organischen Elektrolumineszenzvorrichtung verwendet werden, ist es bevorzugt, wenn die Komplexe nicht geladen, d. h. elektrisch neutral, sind. Dies wird auf einfache Weise dadurch erreicht, dass die Ladung der Liganden L und L' so gewählt werden, dass sie die Ladung des komplexierten Metallatoms M kompensieren. In diesem Fall ist der Index x = 0, und das Gegenion A ist nicht enthalten.

Wenn die Verbindungen gemäß Formel (1) in einer organischen elektrochemischen Vorrichtung, inbesonders in einer organischen lichtemittierenden elektrochemischen Zelle verwendet werden, ist es bevorzugt, wenn die Komplexe geladen sind, d. h. wenn x ungleich 0 ist. Dies wird auf einfache Weise dadurch erreicht, dass die Ladung der Liganden L und L' so gewählt werden, dass sie die Ladung des komplexierten Metallions M nicht kompensieren. In diesem Fall ist mindestens ein Gegenion A enthalten.

Bevorzugt sind weiterhin Verbindungen gemäß Formel (1), dadurch gekennzeichnet, dass die Summe der Valenzelektronen um das Metallatom in vierfach koordinierten Komplexen 16, in fünffach koordinierten Komplexen 16 oder 18 und in sechsfach koordinierten Komplexen 18 beträgt. Diese Bevorzugung ist durch die besondere Stabilität dieser Metallkomplexe begründet.

In einer bevorzugten Ausführungsform der Erfindung steht der Index n steht für 2 oder 3. Wenn der Index n = 1 ist, sind noch vier monodentate oder zwei bidentate oder ein bidentater und zwei monodentate oder ein tridentater und ein monodentater oder ein tetradentater Ligand L', bevorzugt zwei bidentate Liganden L', an das Metall koordiniert. Wenn der Index n = 2 ist, sind noch ein bidentater oder zwei monodentate Liganden L', bevorzugt ein bidentater Ligand L', an das Metall koordiniert. Wenn der Index n = 3 ist, ist der Index m = 0.

Wie oben beschrieben, handelt es sich bei der überbrückenden Gruppe Y um eine zweiatomige Brücke, welche zwei Brückenatome enthält, die gleich oder verschieden bei jedem Auftreten ausgewählt sind aus der Gruppe bestehend aus C, N, O, S, Si und P, wobei diese Brückenatome substituiert oder unsubstituiert sein können. In einer bevorzugten Ausführungsform der Erfindung ist mindestens eines der beiden Brückenatome ein Kohlenstoffatom. In einer besonders bevorzugten Ausführungsform der Erfindung ist eines der beiden Brückenatome ein Kohlenstoffatom und das andere Brückenatom ist ausgewählt aus C, N oder O. Dabei können diese Atome durch Reste R substituiert sein. Bei dem Kohlenstoffatom kann es sich um eine Gruppe $CR_2$ oder um eine Carbonylgruppe handeln. Weiterhin kann es sich bei der Gruppe Y auch um eine Gruppe -RC=CR- oder -RC=N- oder um eine aromatische oder heteroaromatische Gruppe handeln, welche über zwei Kohlenstoffatome oder über ein Kohlenstoffatom und ein Stickstoffatom gebunden ist.

Bevorzugte Brücken Y sind ausgewählt aus den folgenden Strukturen: -CR=CR-, -CR=N-, $-C(=O)-CR_2-$, -C(=O)-NR-, -C(=O)-O- und $-CR_2-CR_2-$sowie aus den Strukturen der folgenden Formeln (A) bis (E),

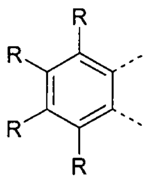 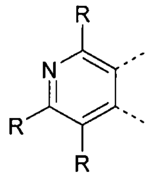 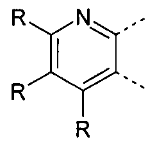 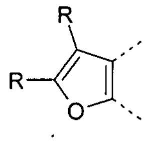 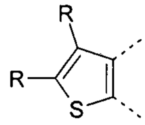

Formel (A) Formel (B) Formel (C) Formel (D) Formel (E)

wobei R die oben genannte Bedeutung aufweist und die gestrichelten Bindungen jeweils die Bindung dieser Gruppe im entsprechenden Liganden andeuten.

Unsymmetrische Brücken Y können erfindungsgemäß in beiden möglichen Orientierungen binden. Dies wird im Folgenden schematisch am Beispiel Y = -C(=O)-O- erläutert:

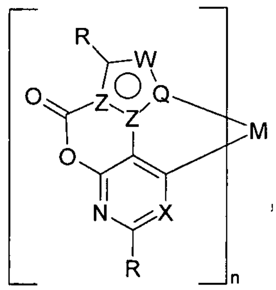 , 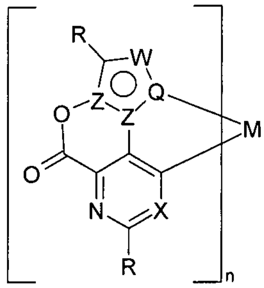

Die Gruppe -C(=O)-O- kann einerseits derart binden, dass die Carbonylgruppe an die Gruppe Z gebunden ist und das Sauerstoffatom an den Sechsring gebinden ist (1. Struktur). Die Gruppe -C(=O)-O- kann andererseits aber auch derart binden, dass die Carbonylgruppe an den Sechsring gebunden ist und das Sauerstoffatom an die Gruppe Z gebunden ist (2. Struktur). Beide Ausführungsformen sind erfindungsgemäß.

Ausführungsformen der Teilstrukturen gemäß Formel (2) sind die Strukturen der folgenden Formeln (8) bis (10),

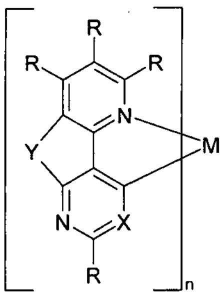

Formel (8)

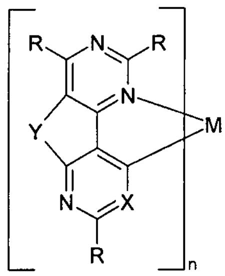

Formel (9)

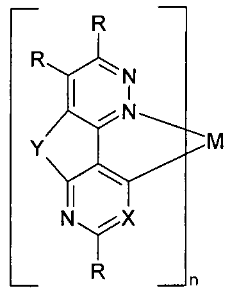

Formel (10) ,

wobei die verwendeten Symbole und Indizes die oben genannten Bedeutungen aufweisen.

Bevorzugt sind die Strukturen der Formel (8) und (9), besonders bevorzugt die Strukturen der Formel (8).

In einer weiteren bevorzugten Ausführungsform der Erfindung steht X in der Teilstruktur gemäß Formel (2) sowie in den Teilstrukturen der Formeln (8) bis (10) für CR, insbesondere für CH.

In einer besonders bevorzugten Ausführungsform der Erfindung treten die oben genannten Bevorzugungen gleichzeitig auf.

Die Reste R in der Teilstruktur der Formel (2) sind bei jedem Auftreten gleich oder verschieden bevorzugt ausgewählt aus der Gruppe bestehend aus H, D, F, Br, I, $N(R^1)_2$, CN, $Si(R^1)_3$, $B(OR^1)_2$, $C(=O)R^1$, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten $R^1$ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste $R^1$ substituiert sein kann; dabei können zwei benachbarte Rest R auch miteinander ein mono- oder polycyclisches, aliphatisches, aromatisches oder heteroaromatisches Ringsystem bilden. Besonders bevorzugt sind diese Reste R bei jedem Auftreten gleich oder verschieden ausgewählt aus der Gruppe bestehend aus H, D, F, $N(R^1)_2$, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste $R^1$ substituiert sein kann; dabei können zwei benachbarte Rest R auch miteinander ein mono- oder polycyclisches, aliphatisches, aromatisches oder heteroaromatisches Ringsystem bilden.

Weiterhin ist es möglich, dass der Substituent R, der in ortho-Position zur Metallkoordination steht, eine Gruppe darstellt, die ebenfalls an das Metall M koordiniert bzw. bindet. Bevorzugte koordinierende Gruppen R sind Aryl- bzw. Heteroarylgruppen, beispielsweise Phenyl oder Pyridyl, Aryl- oder Alkylcyanide, Aryl- oder Alkylisocyanide, Amine oder Amide, Alkohole oder Alkoholate, Thioalkohole oder Thioalkoholate, Phosphine, Phosphite, Carbonylfunktionen, Carboxylate, Carbamide oder Aryl- oder Alkylacetylide. Hier sind beispielsweise die Teilstrukturen ML der folgenden Formeln (11) bis (16) zugänglich:

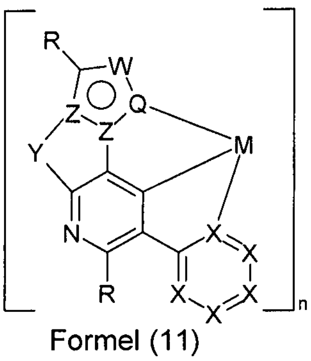
Formel (11)

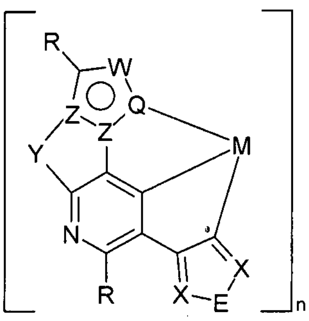
Formel (12)

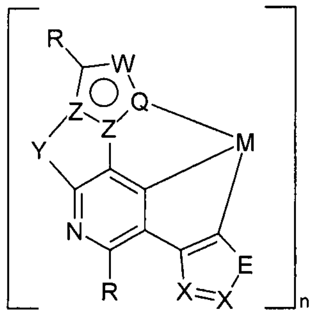
Formel (13)

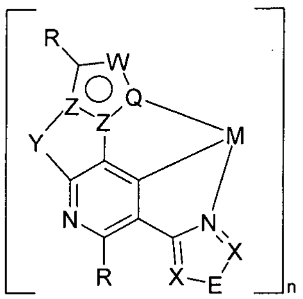
Formel (14)

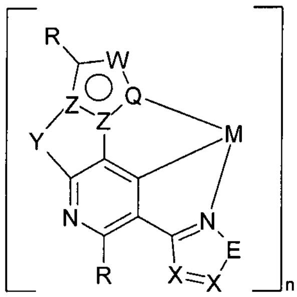
Formel (15)

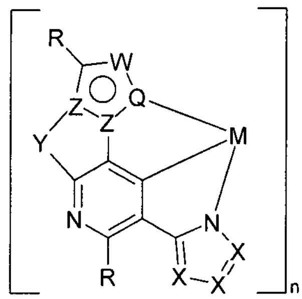
Formel (16)

,

wobei die verwendeten Symbole und Indizes die gleichen Bedeutungen aufweisen, wie oben beschrieben, wobei die koordinierende Gruppe X in Formel (11) für C oder N steht, und E gleich oder verschieden bei jedem Auftreten für S, O oder $NR^1$ steht.

Die Formeln (11) bis (16) zeigen nur exemplarisch, wie der Substituent R zusätzlich an das Metall koordinieren kann. Ganz analog sind ohne weiteres erfinderisches Zutun auch andere an das Metall koordinierende Gruppen R zugänglich.

Wie oben beschrieben, kann auch statt einem der Reste R eine verbrückende Einheit V vorhanden sein, die diesen Liganden L mit einem oder mehreren weiteren Liganden L bzw. L' verknüpft. In einer bevorzugten Ausführungsform der Erfindung ist diese verbrückende Einheit V in ortho- oder meta-Position, insbesondere in ortho-Position zum koordinierenden Atom gebunden. Dadurch weist der Ligand dreizähnigen oder mehrzähnigen oder polypodalen Charakter auf. Es können auch zwei solcher verbrückenden Einheiten V vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (19) und (20),

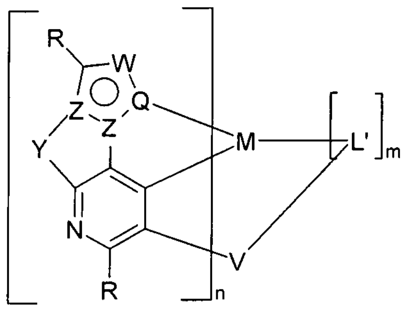
Formel (19)

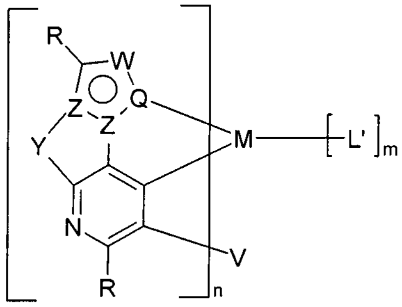
Formel (20)

wobei die verwendeten Symbole die oben genannten Bedeutungen aufweisen, wobei V bevorzugt eine verbrückende Einheit darstellt, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch unsymmetrisch aufgebaut sein, d. h. die Verknüpfung von V zu L bzw. L' muss nicht identisch sein. Die verbrückende Einheit V kann neutral, einfach, zweifach oder dreifach negativ oder einfach, zweifach oder dreifach positiv geladen sein. Bevorzugt ist V neutral oder einfach negativ oder einfach positiv geladen, besonders bevorzugt neutral. Dabei gelten für die Liganden die oben für die Teilstruktur $ML_n$ genannten Bevorzugungen und n ist bevorzugt mindestens 2.

Die genaue Struktur und chemische Zusammensetzung der Gruppe V hat keinen wesentlichen Einfluss auf die elektronischen Eigenschaften des Komplexes, da die Aufgabe dieser Gruppe im Wesentlichen ist, durch die Verbrückung von L miteinander bzw. mit L' die chemische und thermische Stabilität der Komplexe zu erhöhen.

Wenn V eine trivalente Gruppe ist, also drei Liganden L miteinander bzw. zwei Liganden L mit L' oder einen Liganden L mit zwei Liganden L' verbrückt, ist V bevorzugt gleich oder verschieden bei jedem Auftreten gewählt aus der Gruppe bestehend aus B, $B(R^1)^-$, $B(C(R^1)_2)_3$,
$(R^1)B(C(R^1)_2)_3^-$, $B(O)_3$, $(R^1)B(O)_3^-$, $B(C(R^1)_2C(R^1)_2)_3$, $(R^1)B(C(R^1)_2C(R^1)_2)_3^-$, $B(C(R^1)_2O)_3$, $(R^1)B(C(R^1)_2O)_3^-$, $B(OC(R^1)_2)_3$, $(R^1)B(OC(R^1)_2)_3^-$, $C(R^1)$, $CO^-$, $CN(R^1)_2$, $(R^1)C(C(R^1)_2)_3$, $(R^1)C(O)_3$, $(R^1)C(C(R^1)_2C(R^1)_2)_3$, $(R^1)C(C(R^1)_2O)_3$, $(R^1)C(OC(R^1)_2)_3$, $(R^1)C(Si(R^1)_2)_3$, $(R^1)C(Si(R^1)_2C(R^1)_2)_3$,
$(R^1)C(C(R^1)_2Si(R^1)_2)_3$, $(R^1)C(Si(R^1)_2Si(R^1)_2)_3$, $Si(R^1)$, $(R^1)Si(C(R^1)_2)_3$, $(R^1)Si(O)_3$, $(R^1)Si(C(R^1)_2C(R^1)_2)_3$, $(R^1)Si(OC(R^1)_2)_3$, $(R^1)Si(C(R^1)_2O)_3$, $(R^1)Si(Si(R^1)_2)_3$, $(R^1)Si(Si(R^1)_2C(R^1)_2)_3$, $(R^1)Si(C(R^1)_2Si(R^1)_2)_3$, $(R^1)Si(Si(R^1)_2Si(R^1)_2)_3$, N, NO, $N(R^1)^+$, $N(C(R^1)_2)_3$, $(R^1)N(C(R^1)_2)_3^+$, $N(C{=}O)_3$, $N(C(R^1)_2C(R^1)_2)_3$, $(R^1)N(C(R^1)_2C(R^1)_2)^+$, P, $P(R^1)^+$, PO, PS, $P(O)_3$, $PO(O)_3$, $P(OC(R^1)_2)_3$, $PO(OC(R^1)_2)_3$, $P(C(R^1)_2)_3$, $P(R^1)(C(R^1)_2)_3^+$, $PO(C(R^1)_2)_3$, $P(C(R^1)_2C(R^2)_2)_3$, $P(R^1)\ (C(R^1)_2C(R^1)_2)_3^+$, $PO(C(R^1)_{2C}(R^1)_2)_3$, $S^+$, $S(C(R^1)_2)_3^+$, $S(C(R^1)_2C(R^1)_2)_3^+$,
oder eine Einheit gemäß Formel (23), (24), (25) oder (26),

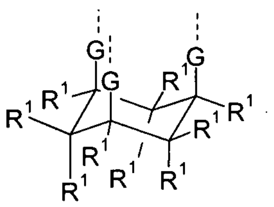
Formel (23)

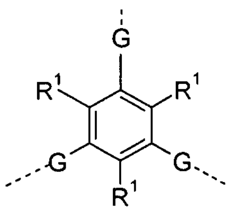
Formel (24)

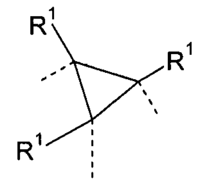
Formel (25)

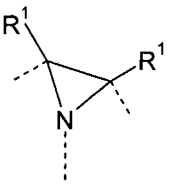
Formel (26)

wobei die gestrichelten Bindungen jeweils die Bindung zu den Teilliganden L bzw. L' andeuten und G gleich oder verschieden bei jedem Auftreten ausgewählt ist aus der Gruppe bestehend aus einer Einfachbindung, O, S, S(=O), $S(=O)_2$, $NR^1$, $PR^1$, $P(=O)R^1$, $P(=NR^1)$, $C(R^1)_2$, C(=O), $C(=NR^1)$, $C(=C(R^1)_2)$, $Si(R^1)_2$ oder $BR^1$. Die weiteren verwendeten

Symbole haben die oben genannten Bedeutungen.

Wenn V eine bivalente Gruppe ist, also zwei Liganden L miteinander bzw. einen Liganden L mit L' verbrückt, ist V bevorzugt gleich oder verschieden bei jedem Auftreten gewählt aus der Gruppe bestehend aus $BR^1$, $B(R^1)_2^-$, $C(R^1)_2$, C(=O), $Si(R^1)_2$, $NR^1$, $PR^1$, $P(R^1)_2^+$, $P(=O)(R^1)$, $P(=S)(_{R}{}^1)$, O, S, Se, oder eine Einheit gemäß Formel (27) bis (35),

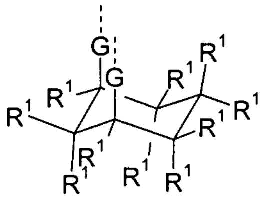
Formel (27)

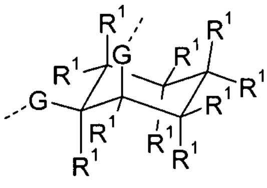
Formel (28)

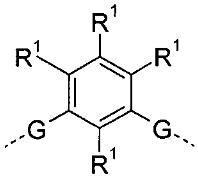
Formel (29)

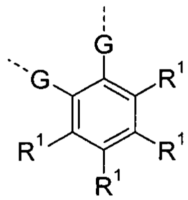
Formel (30)

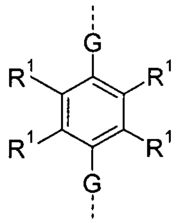
Formel (31)

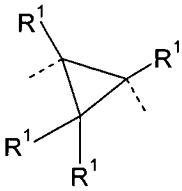
Formel (32)

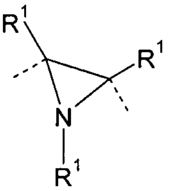
Formel (33)

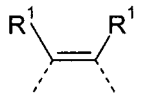
Formel (34)

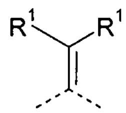
Formel (35)

wobei die gestrichelten Bindungen jeweils die Bindung zu den Teilliganden L bzw. L' andeuten und die verwendeten Symbole jeweils die oben aufgeführten Bedeutungen haben.

Im Folgenden werden bevorzugte Liganden L' beschrieben, wie sie in Formel (1) vorkommen. Entsprechend können auch die Ligandengruppen L' gewählt sein, wenn diese über eine verbrückende Einheit V an L gebunden sind, wie in Formeln (19) und (20) angedeutet.

Die Liganden L' sind bevorzugt neutrale, monoanionische, dianionische oder trianionische Liganden, besonders bevorzugt neutrale oder monoanionische Liganden. Sie können monodentat, bidentat, tridentat oder tetradentat sein und sind bevorzugt bidentat, weisen also bevorzugt zwei Koordinationsstellen auf. Wie oben beschrieben, können die Liganden L' auch über eine verbrückende Gruppe V an L gebunden sein.

Bevorzugte neutrale, monodentate Liganden L' sind ausgewählt aus der Gruppe bestehend aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Dimethylphenylphosphin, Methyldiphenylphosphin, Bis(tert-butyl)phenylphosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L' sind ausgewählt aus Hydrid, Deuterid, den Halogeniden $F^-$, $Cl^-$, $Br^-$ und $I^-$, Alkylacetyliden, wie z. B. Methyl-C≡C$^-$, tert-Butyl-C≡C$^-$, Arylacetyliden, wie z. B. Phenyl-C≡C$^-$, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt $C_1$-$C_{20}$-Alkylgruppen, besonders bevorzugt $C_1$-$C_{10}$-Alkylgruppen, ganz besonders bevorzugt $C_1$-$C_4$-Alkylgruppen. Unter einer Arylgruppe werden auch Heteroarylgruppen verstanden. Diese Gruppen sind wie oben definiert.

Bevorzugte di- bzw. trianionische Liganden sind $O^{2-}$, $S^{2-}$, Carbide, welche zu einer Koordination der Form R-C≡M führen, und Nitrene, welche zu einer Koordination der Form R-N=M führen, wobei R allgemein für einen Substituenten steht, oder $N^{3-}$.

Bevorzugte neutrale oder mono- oder dianionische, bidentate oder höherdentate Liganden L' sind ausgewählt

aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]pyridin, 2-[1-(2-Methylphenylimino)ethyl]pyridin, 2-[1-(2,6-Di-*iso*-propylphenylimino)ethyl]pyridin, 2-[1-(Methylimino)ethyl]pyridin, 2-[1-(ethylimino)ethyl]pyridin, 2-[1-(*Iso*-Propylimino)ethyl]pyridin, 2-[1-(*Tert*-Butylimino)ethyl]pyridin, Diiminen, wie z. B. 1,2-Bis(methylimino)ethan, 1,2-Bis(ethylimino)ethan, 1,2-Bis(*iso*-propylimino)ethan, 1,2-Bis(*tert*-butylimino)ethan, 2,3-Bis(methylimino)butan, 2,3-Bis(ethylimino)butan, 2,3-Bis-(*iso*-propylimino)butan, 2,3-Bis(*tert*-butylimino)butan, 1,2-Bis(phenylimino)-ethan, 1,2-Bis(2-methylphenylimino)ethan, 1,2-Bis(2,6-di-*iso*-propylphenylimino)ethan, 1,2-Bis(2,6-di-*tert*-butylphenylimino)ethan, 2,3-Bis(phenylimino)butan, 2,3-Bis(2-methylphenylimino)butan, 2,3-Bis(2,6-di-*iso*-propylphenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)propan, Bis(diphenylphosphino)butan, Bis(dimethylphosphino)methan, Bis(dimethylphosphino)ethan, Bis(dimethylphosphino)propan, Bis(diethylphosphino)-methan, Bis(diethylphosphino)ethan, Bis(diethylphosphino)propan, Bis(di-*tert*-butylphosphino)methan, Bis(di-*tert*-butylphosphino)ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugte tridentate Liganden sind Borate stickstoffhaltiger Heterocyclen, wie z. B. Tetrakis(1-imidazolyl)borat und Tetrakis(1-pyrazolyl)borat.

Bevorzugt sind weiterhin bidentate monoanionische, neutrale oder dianionische Liganden L', insbesondere monoanionische Liganden, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (36) bis (63) dargestellt sind, wobei eine Gruppe bevorzugt über ein neutrales Stickstoffatom oder ein Carbenkohlenstoffatom bindet und die andere Gruppe bevorzugt über ein negativ geladenes Kohlenstoffatom oder ein negativ geladenes Stickstoffatom bindet. Der Ligand L' kann dann aus den Gruppen der Formeln (36) bis (63) gebildet werden, indem diese Gruppen jeweils an der durch # gekennzeichneten Position aneinander binden. Die Position, an der die Gruppen an das Metall koordinieren, sind durch * gekennzeichnet. Diese Gruppen können auch über eine oder zwei verbrückende Einheiten V an den Liganden L gebunden sein.

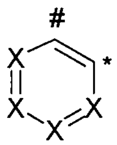
Formel (36)

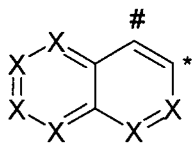
Formel (37)

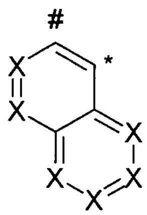
Formel (38)

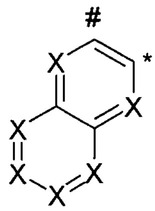
Formel (39)

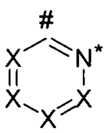
Formel (40)

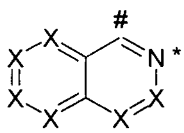
Formel (41)

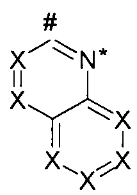
Formel (42)

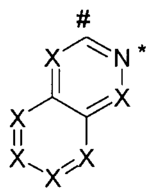
Formel (43)

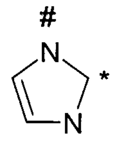
Formel (44)

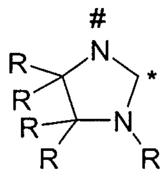
Formel (45)

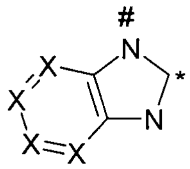
Formel (46)

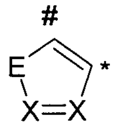
Formel (47)

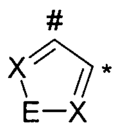
Formel (48)

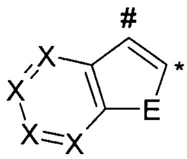
Formel (49)

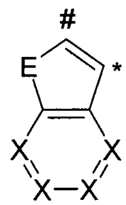
Formel (50)

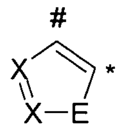
Formel (51)

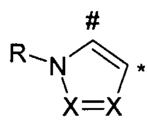
Formel (52)

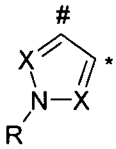
Formel (53)

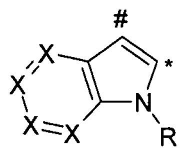
Formel (54)

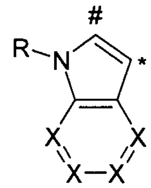
Formel (55)

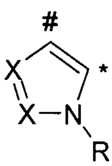
Formel (56)

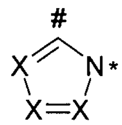
Formel (57)

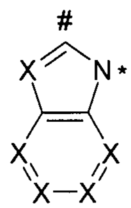
Formel (58)

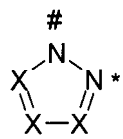
Formel (59)

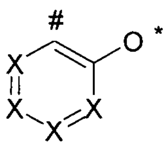
Formel (60)

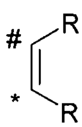
Formel (61)

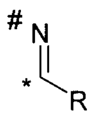
Formel (62)

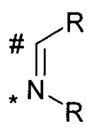
Formel (63)

Dabei steht E bei jedem Auftreten gleich oder verschieden für S oder O. Weiterhin steht X bei jedem Auftreten gleich oder verschieden für CR oder N, und R hat dieselbe Bedeutung wie oben beschrieben. Bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Ebenfalls bevorzugte Liganden L' sind $\eta^5$-Cyclopentadienyl, $\eta^5$-Pentamethylcyclopentadienyl, $\eta^6$-Benzol oder $\eta^7$-Cycloheptatrienyl, welche jeweils durch einen oder mehrere Reste R substituiert sein können.

Bevorzugte Reste R in den oben aufgeführten Strukturen sind bei jedem Auftreten gleich oder verschieden ausgewählt aus der Gruppe bestehend aus H, D, F, Br, $N(R^1)_2$, CN, $B(OR^1)_2$, $C(=O)R^1$, $P(=O)(R^1)_2$, einer geradkettigen Alkylgruppe mit 1 bis 10 C-Atomen oder einer Alkenyl- oder Alkinylgruppe mit 2 bis 10 C-Atomen oder einer verzweigten oder cyclischen Alkylgruppe mit 3 bis 10 C-Atomen, die jeweils mit einem oder mehreren Resten $R^1$ substituiert sein kann, wobei ein oder mehrere H-Atome durch D oder F ersetzt sein können, oder einem aromatischen oder heteroaromatischen Ringsystem mit 5 bis 14 aromatischen Ringatomen, das jeweils durch einen oder mehrere Reste $R^1$ substituiert sein kann; dabei können zwei oder mehrere benachbarte Reste R auch miteinander ein mono- oder polycyclisches, aliphatisches, aromatisches und/oder benzoannelliertes Ringsystem bilden. Besonders bevorzugte Reste R sind bei jedem Auftreten gleich oder verschieden ausgewählt aus der Gruppe bestehend aus H, D, F, Br, CN, $B(OR^1)_2$, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste $R^1$ substituiert sein kann; dabei können zwei oder mehrere Reste R auch miteinander ein mono- oder polycyclisches, aliphatisches, aromatisches und/oder benzoannelliertes Ringsystem bilden.

Wenn die Komplexe geladen sind, liegt der Komplex zusammen mit einem Gegenion A vor. Wenn der Komplex positiv geladen ist, sind die Gegenionen A bevorzugt ausgewählt aus der Gruppe bestehend aus Fluorid, Chlorid, Bromid, Iodid, Hydroxid, Tetrafluoroborat, Hexafluorophosphat, Sulfat, Phosphat, Nitrat, Carbonat, Alkylcarboxylat, wobei die Alkylgruppe bevorzugt 1 bis 20 C-Atome aufweist, oder Arylcarboxylat. Wenn der Komplex negativ geladen ist, sind die Gegenionen A bevorzugt ausgewählt aus der Gruppe bestehend aus Lithium, Natrium, Kalium, Ammonium, Tetraalkylammonium oder Tetraalkylphosphonium, wobei die Alkylgruppe jeweils bevorzugt 1 bis 10 C-Atome aufweist.

Die erfindungsgemäßen Komplexe können facial bzw. pseudofacial sein, oder sie können meridional bzw. pseudomeridional sein.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für erfindungsgemäßen Verbindungen gemäß Formel (1) sind die in der folgenden Tabelle aufgeführten Verbindungen.

| | | |
|---|---|---|
| 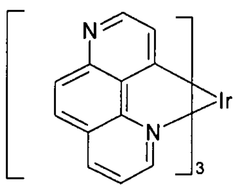 | 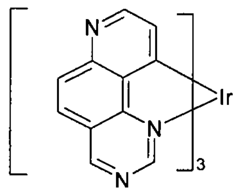 | 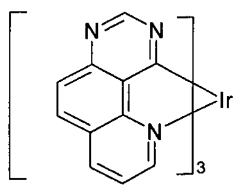 |
| (1) | (2) | (3) |
| 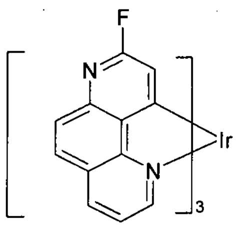 | 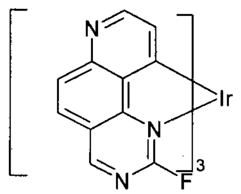 | 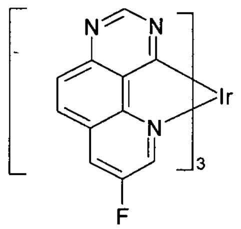 |
| (4) | (5) | (6) |
| 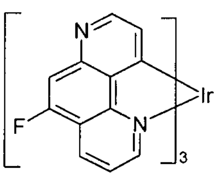 | 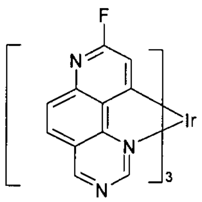 | 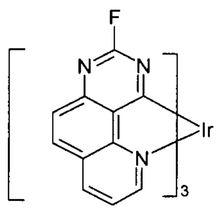 |
| (7) | (8) | (9) |
| 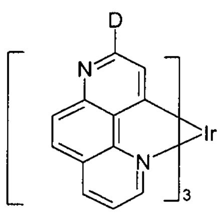 | 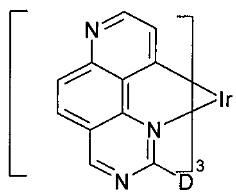 | 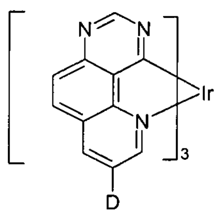 |

(fortgesetzt)

| | | |
|---|---|---|
| (10) | (11) | (12) |
| 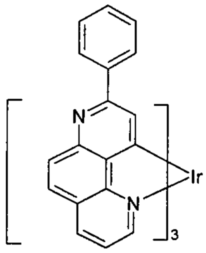 | 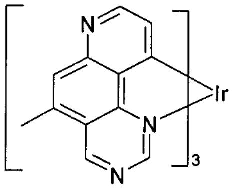 | 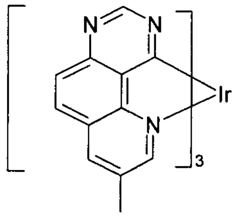 |
| (13) | (14) | (15) |
| 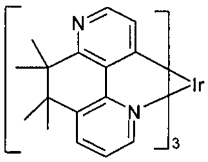 | 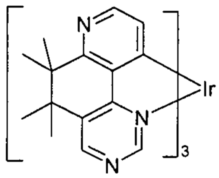 | 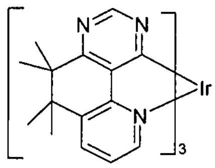 |
| (16) | (17) | (18) |
| 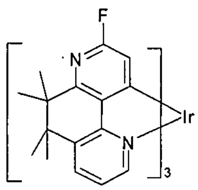 | 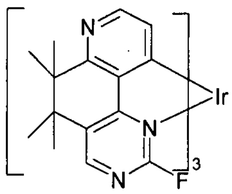 | 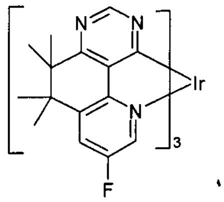 |
| (19) | (20) | (21) |
| 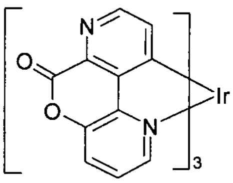 | 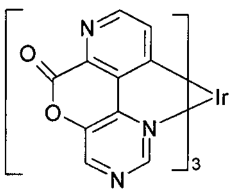 | 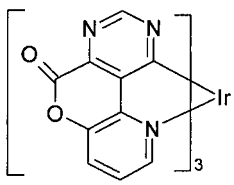 |
| (40) | (41) | (42) |
| 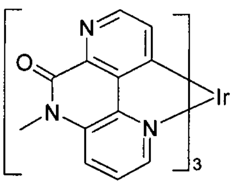 | 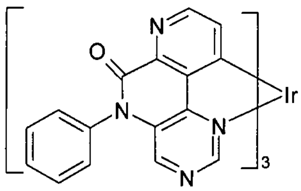 | 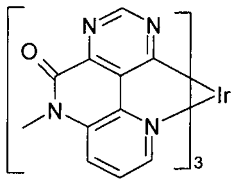 |
| (43) | (44) | (45) |
| 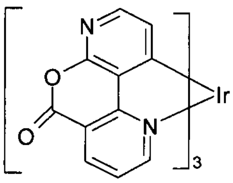 | 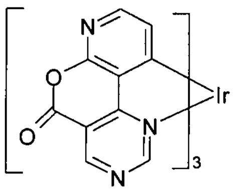 | 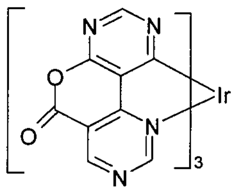 |
| (46) | (47) | (48) |

(fortgesetzt)

| | | |
|---|---|---|
| 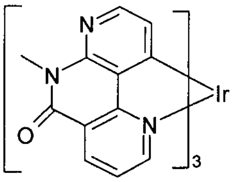 | 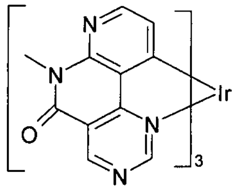 | 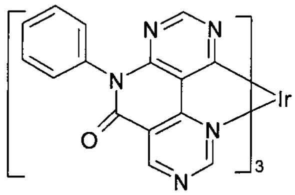 |
| (49) | (50) | (51) |
| 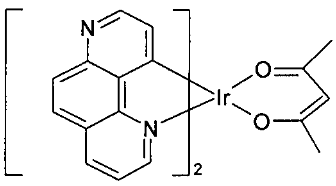 | 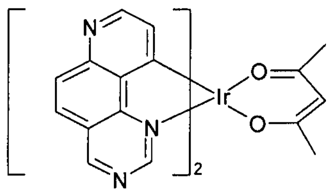 | 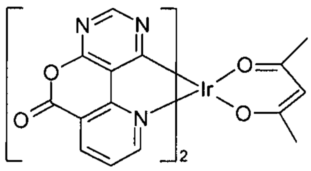 |
| (61) | (62) | (63) |
| 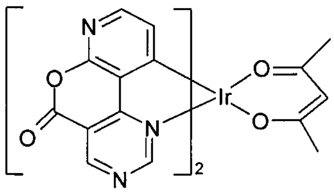 | 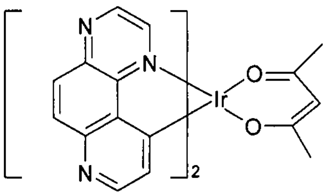 | 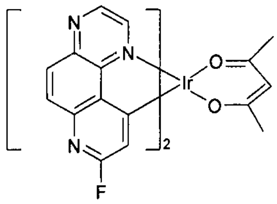 |
| (64) | (65) | (66) |
| 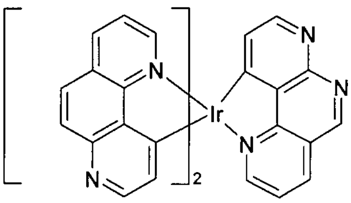 | 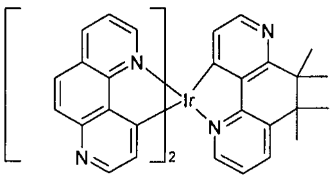 | 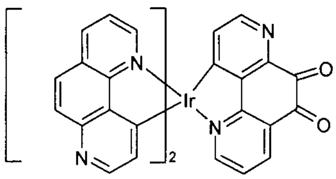 |
| (67) | (68) | (69) |

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der Metallkomplex-Verbindungen gemäß Formel (1) durch Umsetzung der entsprechenden freien Liganden mit Metallalkoholaten der Formel (64), mit Metallketoketonaten der Formel (65), mit Metallhalogeniden der Formel (66) oder mit dimeren Metallkomplexen der Formel (67),

$M(OR)_n$

Formel (64)

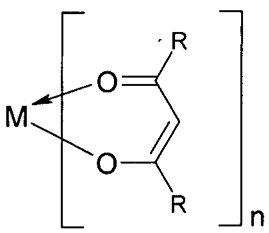

Formel (65)

$MHal_n$

Formel (66)

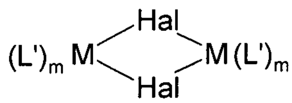

Formel (67)

wobei die Symbole M, m, n und R die oben angegebenen Bedeutungen haben und Hal = F, Cl, Br oder I ist.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende

Iridiumverbindungen, die als Edukte besonders geeignet sind, sind in WO 2004/085449 offenbart. Besonders geeignet sind $[IrCl_2(acac)_2]^-$, beispielsweise $Na[IrCl_2(acac)_2]$, Metallkomplexe mit Acetylacetonat-Derivaten als Ligand, beispielsweise $Ir(acac)_3$ oder Tris(2,2,6,6-tetramethylheptan-3,5-dionato)iridium, und $IrCl_3 \cdot xH_2O$, wobei x üblicherweise für eine Zahl zwischen 2 und 4 steht.

Die Synthese der Komplexe wird bevorzugt durchgeführt wie in WO 2002/060910, WO 2004/085449 und WO 2007/065523 beschrieben. Heteroleptische Komplexe können beispielsweise auch gemäß WO 2005/042548 synthetisiert werden. Dabei kann die Synthese beispielsweise auch thermisch, photochemisch und/oder durch Mikrowellenstrahlung aktiviert werden. In einer bevorzugten Ausführungsform der Erfindung wird die Reaktion ohne die Verwendung eines zusätzlichen Lösemittels in der Schmelze durchgeführt. Dabei bedeutet "Schmelze", dass der Ligand geschmolzen vorliegt und die Metall-Vorstufe in dieser Schmelze gelöst oder suspendiert ist.

Durch diese Verfahren lassen sich die erfindungsgemäßen Verbindungen gemäß Formel (1) in hoher Reinheit, bevorzugt mehr als 99 % (bestimmt mittels $^1$H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Ein weiterer Gegenstand der vorliegenden Erfindung ist daher eine Formulierung, insbesondere eine Lösung, eine Dispersion oder eine Miniemulsion, enthaltend mindestens eine erfindungsgemäße Verbindung und mindestens ein Lösemittel, insbesondere ein organisches Lösemittel.

Die oben beschriebenen Komplexe gemäß Formel (1) bzw. die oben aufgeführten bevorzugten Ausführungsformen können in der elektronischen Vorrichtung als aktive Komponente verwendet werden. Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen lichtemittierenden Transistoren (O-LETs), organischen lichtemittierenden elektrochemischen Zellen (LECs), organischen lichtemittierenden elektrochemischen Transistoren (C. Yumusak, Appl. Phys. Lett. 2010, 97, 03302), organischen integrierten Schaltungen (O-ICs), organischen Feld-Effekt-Transistoren (O-FETs), organischen Dünnfilmtransistoren (O-TFTs), organischen Solarzellen (O-SCs), organischen optischen Detektoren, organischen Photorezeptoren, organischen Feld-Quench-Devices (O-FQDs), Organic Plasmon Emitting Device (D. M. Koller et al., Nature Photonics 2008, 2, 684) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen und lichtemittierende elektrochemische Zellen.

Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen und in lichtemittierenden elektrochemischen Zellen. Eine bevorzugte Ausführungsform der Erfindung sind daher organische Elektrolumineszenzvorrichtungen und lichtemittierende elektrochemische Zellen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Excitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder

mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Wenn die organische Elektrolumineszenzvorrichtung durch Aufdampfen der Materialien aus der Gasphase hergestellt wird, enthält die Mischung aus der Verbindung gemäß Formel (1) und dem Matrixmaterial zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial. Wenn die organische Elektrolumineszenzvorrichtung aus Lösung hergestellt wird, enthält die Mischung aus der Verbindung gemäß Formel (1) und dem Matrixmaterial zwischen 0.1 und 99 Gew.-%, vorzugsweise zwischen 1 und 90 Gew.-%, besonders bevorzugt zwischen 3 und 40 Gew.-%, insbesondere zwischen 10 und 20 Gew.-% der Verbindung gemäß Formel (1) bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 90 und 80 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$,

$BaF_2$, MgO, NaF, CsF, $Cs_2CO_3$, etc.). Ebenso kommen hierfür organische Alkalimetallkomplexe in Frage, z. B. LiQ (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/$NiO_x$, Al/$PtO_x$) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner $10^{-5}$ mbar, bevorzugt kleiner $10^{-6}$ mbar aufgedampft. Es ist auch möglich, dass der Anfangsdruck noch geringer oder noch höher ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Einige der Hauptanwendungsgebiete der lichtemittierenden Vorrichtungen enthaltend die erfindungsgemäßen Verbindungen sind dabei Display- oder Beleuchtungstechnologien. Weiterhin ist es besonders vorteilhaft, die Verbindungen sowie Vorrichtungen enthaltend diese Verbindungen im Bereich der Phototherapie einzusetzen.

Ein weiterer Gegenstand der vorliegenden Erfindung bezieht sich daher auf die Verwendung der erfindungsgemäßen Verbindungen und Vorrichtungen enthaltend die erfindungsgemäßen Verbindungen zur Behandlung, Prophylaxe und Diagnose von Erkrankungen. Noch ein weiterer Gegenstand der vorliegenden Erfindung bezieht sich auf die Verwendung, der erfindungsgemäßen Verbindungen und Vorrichtungen enthaltend die erfindungsgemäßen Verbindungen zur Behandlung und Prophylaxe von kosmetischen Umständen.

Ein weiterer Gegenstand der vorliegenden Erfindung bezieht sich auf die erfindungsgemäßen Verbindungen zu Herstellung von Vorrichtungen zur Therapie, Prophylaxe und/oder Diagnose von Erkrankungen.

Dabei sind viele Erkrankungen mit kosmetischen Aspekten assoziiert. So leidet ein Patient mit schwerer Akne in der Gesichtspartie nicht nur an den medizinischen Ursachen und Folgen der Erkrankung, sondern auch an den kosmetischen Begleitumständen.

Phototherapie oder Lichttherapie findet in vielen medizinischen und/oder kosmetischen Bereichen Anwendung. Die erfindungsgemäßen Verbindungen sowie die Vorrichtungen enthaltend diese Verbindungen können daher zur Therapie und/oder Prophylaxe und/oder Diagnose aller Erkrankungen und/oder in allen kosmetischen Anwendungen eingesetzt werden, für die der Fachmann die Anwendung von Phototherapie in Betracht zieht. Der Begriff Phototherapie beinhaltet dabei neben der Bestrahlung auch die photodynamische Therapie (PDT) sowie das Desinfizieren und Sterilisieren im Allgemeinen. Behandelt werden können mittels Phototherapie oder Lichttherapie nicht nur Menschen oder Tiere, sondern auch jegliche andere Art lebender oder unbelebter Materie. Hierzu gehören beispielsweise Pilze, Bakterien, Mikroben, Viren, Eukaryonten, Prokaryonten, Nahrungsmittel, Getränke, Wasser und Trinkwasser.

Der Begriff Phototherapie beinhaltet auch jede Art der Kombination von Lichttherapie und anderen Therapiearten, wie beispielsweise die Behandlung mit Wirkstoffen. Viele Lichttherapien haben zum Ziel, äußere Partien eines Objektes zu bestrahlen oder zu behandeln, so wie die Haut, Wunden, Schleimhäute, Auge, Haare, Nägel, das Nagelbett, Zahnfleisch und die Zunge von Menschen und Tieren. Die erfindungsgemäße Behandlung oder Bestrahlung kann daneben auch innerhalb eines Objektes durchgeführt werden, um beispielsweise innere Organe (Herz, Lunge, etc.), Blutgefäße oder die Brust zu behandeln.

Die erfindungsgemäßen therapeutischen und/oder kosmetischen Anwendungsgebiete sind bevorzugt ausgewählt aus der Gruppe der Hauterkrankungen und Haut-assoziierten Erkrankungen oder Veränderungen bzw. Umstände wie beispielsweise Psoriasis, Hautalterung, Hautfaltenbildung, Hautverjüngung, vergrößerte Hautporen, Cellulite, ölige/fettige Haut, Follikulitis, aktinische Keratose, precancerose aktinische Keratose, Hautläsionen, sonnengeschädigte und sonnengestresste Haut, Krähenfüße, Haut Ulkus, Akne, Akne rosacea, Narben durch Akne, Akne-Bakterien, Photomodulierung fettiger/öliger Talgdrüsen sowie deren umgebende Gewebe, Ikterus, Neugeborenenikterus, Vitiligo, Hautkrebs, Hauttumore, Crigler Naijar, Dermatitis, atopische Dermatitis, diabetische Hautgeschwüre sowie Desensibilisierung der Haut.

Besonders bevorzugt im Sinne der Erfindung sind die Behandlung und/oder Prophylaxe von Psoriasis, Akne, Cellulite, Hautfaltenbildung, Hautalterung, Ikterus und Vitiligo.

Weitere erfindungsgemäße Anwendungsgebiete für die erfindungsgemäßen Zusammensetzungen und/oder Vorrichtungen enthaltend die erfindungsgemäßen Zusammensetzungen sind ausgewählt aus der Gruppe der Entzündungserkrankungen, rheumatoide Arthritis, Schmerztherapie, Behandlung von Wunden, neurologische Erkrankungen und Umstände, Ödeme, Paget's Erkrankung, primäre und metastasierende Tumoren, Bindegewebserkrankungen bzw. -veränderungen, Veränderungen des Kollagens, Fibroblasten und von Fibroblasten stammende Zellspiegel in Geweben von Säugetieren, Bestrahlung der Retina, neovasculare und hypertrophe Erkrankungen, allergische Reaktionen, Bestrahlung der Atemwege, Schwitzen, okulare neovaskulare Erkrankungen, virale Infektionen besonders Infektionen durch Herpes Simplex oder HPV (Humane Papillomviren) zur Behandlung von Warzen und Genitalwarzen. Besonders bevorzugt im Sinne der Erfindung sind die Behandlung und/oder Prophylaxe von rheumatoider Arthritis, viraler Infektionen und Schmerzen.

Weitere erfindungsgemäße Anwendungsgebiete für die erfindungsgemäßen Verbindungen und/oder Vorrichtungen enthaltend die erfindungsgemäßen Verbindungen sind ausgewählt aus der Winterdepression, Schlafkrankheit, Bestrahlung zur Verbesserung der Stimmung, Linderung von Schmerzen besonders Muskelschmerzen durch beispielsweise Verspannungen oder Gelenkschmerzen, Beseitigung der Steifheit von Gelenken und das Aufhellen der Zähne (Bleaching).

Weitere erfindungsgemäße Anwendungsgebiete für die erfindungsgemäßen Verbindungen und/oder Vorrichtungen enthaltend die erfindungsgemäßen Verbindungen sind ausgewählt aus der Gruppe der Desinfektionen. Mit den erfindungsgemäßen Verbindungen und/oder mit den erfindungsgemäßen Vorrichtungen können jegliche Art von Objekten (unbelebte Materie) oder Subjekten (lebende Materie wie beispielsweise Mensch und Tier) zum Zweck der Desinfektion, Sterilisation oder Konservierung behandelt werden. Hierzu zählt zum Beispiel die Desinfektion von Wunden, die Reduktion von Bakterien, das Desinfizieren chirurgischer Instrumente oder anderer Gegenstände, das Desinfizieren oder Konservieren von Nahrungs- und Lebensmitteln, von Flüssigkeiten, insbesondere Wasser, Trinkwasser und andere Getränke, das Desinfizieren von Schleimhäuten, Zahnfleisch und Zähnen. Unter Desinfektion wird hierbei die Reduktion lebender mikrobiologischer Verursacher unerwünschter Effekte, wie Bakterien und Keime, verstanden.

Zu dem Zweck der oben genannten Phototherapie emittieren Vorrichtungen enthaltend die erfindungsgemäßen Verbindungen bevorzugt Licht der Wellenlänge zwischen 250 and 1250 nm, besonders bevorzugt zwischen 300 and 1000 nm und insbesondere bevorzugt zwischen 400 and 850 nm. Da viele der erfindungsgemäßen Verbindungen im blauen oder sogar im ultravioletten Bereich emittieren und somit Licht hoher Energie emittieren, wie es häufig für die Phototherapie erforderlich ist, eignen sich die erfindungsgemäßen Verbindungen besonders gut für die Phototherapie.

In einer besonders bevorzugten Ausführungsform der vorliegenden Erfindung werden die erfindungsgemäßen Verbindungen in einer organischen lichtemittierenden Diode (OLED) oder einer organischen lichtemittierenden elektrochemischen Zelle (OLEC) zum Zwecke der Phototherapie eingesetzt. Sowohl die OLED als auch die OLEC können dabei einen planaren oder Fiber- bzw. Faser-artigen Aufbau mit beliebigem Querschnitt (z. B. rund, oval, polygonal, quadratisch) mit einem ein- oder mehrschichtigen Aufbau aufweisen. Diese OLECs und/oder OLEDs können in andere Vorrichtungen eingebaut werden, die weitere mechanische, adhäsive und/oder elektronische Bausteine (z. B. Batterie und/oder Steuerungseinheit zur Einstellung der Bestrahlungszeiten, -intensitäten und -wellenlängen) enthalten. Diese Vorrichtungen enthaltend die erfindungsgemäßen OLECs und/order OLEDs sind vorzugsweise ausgewählt aus der Gruppe enthaltend Pflaster, Pads, Tapes, Bandagen, Manschetten, Decken, Hauben, Schlafsäcken,Textilien und Stents.

Die Verwendung der genannten Vorrichtungen zu dem genannten therapeutischen und/oder kosmetischen Zweck ist besonders vorteilhaft gegenüber dem Stand der Technik, da mit Hilfe der erfindungsgemäßen Vorrichtungen unter Verwendung der OLEDs und/oder OLECs homogene Bestrahlungen geringerer Bestrahlungsintensitäten an nahezu jedem Ort und zu jeder Tageszeit möglich sind. Die Bestrahlungen können stationär, ambulant und/oder selbst, d.h., ohne Einleitung durch medizinisches oder kosmetisches Fachpersonal durchgeführt werden. So können beispielsweise Pflaster unter der Kleidung getragen werden, so dass eine Bestrahlung auch während der Arbeitszeit, in der Freizeit oder während des Schlafes möglich ist. Auf aufwendige stationäre oder ambulante Behandlungen kann in vielen Fällen verzichtet bzw. deren Häufigkeit reduziert werden. Die erfindungsgemäßen Vorrichtungen können zum Wiedergebrauch gedacht sein oder Wegwerfartikel darstellen, die nach ein-, zwei oder dreimaligem Gebrauch entsorgt werden können.

Weitere Vorteile gegenüber dem Stand der Technik sind beispielsweise eine geringere Wärmeentwicklung und emotionale Aspekte. So werden Neugeborene, die aufgrund einer Gelbsucht (Ikterus) therapiert werden müssen, typischerweise mit verbundenen Augen in einem Brutkasten ohne körperlichen Kontakt zur den Eltern bestrahlt, was eine emotionale Stresssituation für Eltern und Neugeborene darstellt. Mit Hilfe einer erfindungsgemäßen Decke enthaltend die erfindungsgemäßen OLEDs und/oder OLECs kann der emotionale Stress signifikant vermindert werden. Zudem ist eine bessere Temperierung des Kindes durch eine verringerte Wärmeproduktion der erfindungsgemäßen Vorrichtungen gegenüber herkömmlichen Bestrahlungsgeräten möglich. Diese oben genannten Vorteile gehen nicht mit einer Verschlechterung der weiteren elektronischen Eigenschaften einher.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbartes Merkmal, sofern nichts anderes gesagt wurde, als Beispiel einer generischen Reihe oder als äquivalentes oder ähnliches Merkmal zu betrachten.

Die erfindungsgemäßen elektronischen Vorrichtungen, insbesondere organische Elektrolumineszenzvorrichtungen, die die erfindungsgemäßen Verbindungen enthalten, zeichnen sich durch einen oder mehrere der folgenden überraschenden Vorteile gegenüber dem Stand der Technik aus:

1. Organische Elektrolumineszenzvorrichtungen enthaltend Verbindungen gemäß Formel (1) als emittierende Materialien weisen eine sehr gute Lebensdauer auf.

2. Organische Elektrolumineszenzvorrichtungen enthaltend Verbindungen gemäß Formel (1) als emittierende Materialien weisen eine hervorragende Effizienz auf.

3. Mit den erfindungsgemäßen Metallkomplexen sind organische Elektrolumineszenzvorrichtungen zugänglich, welche im blauen Farbbereich mit sehr guten Farbkoordinaten phosphoreszieren. Insbesondere blaue Phosphoreszenz ist gemäß dem Stand der Technik nur sehr schwierig mit guten Effizienzen und Lebensdauern zu verwirklichen.

4. Die erfindungsgemäßen Metallkomplexe sind synthetisch gut und in hoher Ausbeute zugänglich.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

**Beispiele:**

**Beispiel 1: Synthese der Metallkomplexe**

Die nachfolgenden Synthesen werden - sofern nicht anders angegeben - unter einer Schutzgasatmosphäre in getrockneten Lösungsmittel durchgeführt. Die Edukte können von den Firmen ALDRICH bzw. ABCR bezogen werden. Die Angaben in eckigen Klammern beziehen sich auf die CAS-Nummern der literaturbekannten Vorstufen und Liganden.

**A)Allgemeine Synthese des dimeren μ-Chloro-Precursorkomplexes**

1 Äquivalent Iridiumtrichlorid-Monohydrat und 2 bis 2.5 Äquivalente des Liganden werden in einer Mischung aus destilliertem Ethoxyethanol und Wasser in Verhältnis 3:1 suspendiert und über Nacht unter Rückfluss erhitzt. Man saugt den Niederschlag ab, engt das Filtrat ein, lässt abkühlen und filtriert nochmals. Der weiße Feststoff wird mit Ethanol und Aceton so lange gewaschen, bis das Filtrat klar abläuft.

Nach dieser allgemeinen Synthese werden folgende Verbindungen erhalten:

| Bsp. | Edukt 1 | Produkt | Ausbeute |
|---|---|---|---|
| A1 | 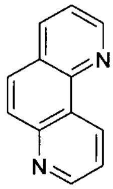 [230-46-6] | 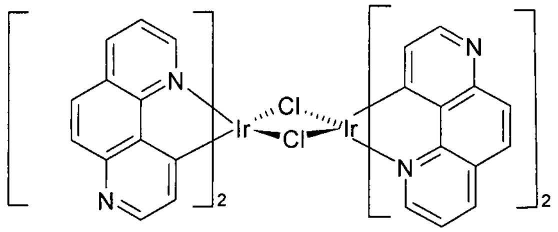 | 88 % |
| A2 | 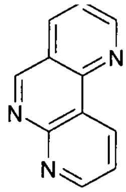 [230-53-5] | 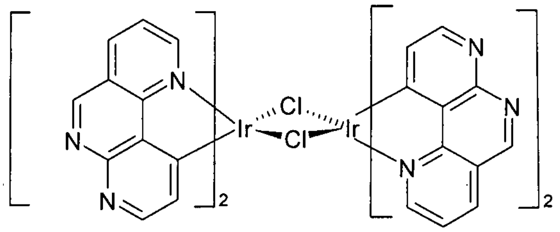 | 81 % |
| A3 | 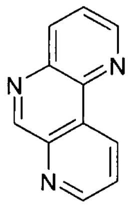 [230-49-9] | 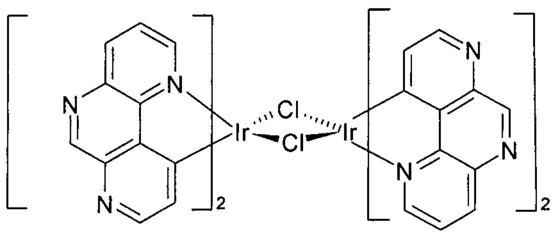 | 63% |
| A4 | 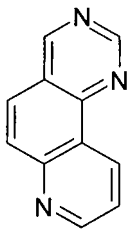 [230-47-7] | 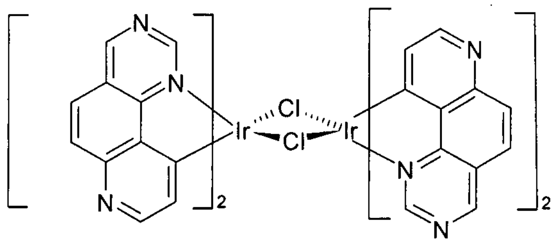 | 44% |

**B) Allgemeine Synthese der Ir(III) Komplexe**

In 2.7 mL entgastem Ethoxyethanol werden 0.64 mmol des dimeren μ-Chloro-Precursorkomplex $Ir_2(L)_4Cl_2$ und 329 mg (1.28 mmol) Silbertriflat suspendiert und 3.84 mmol Ligand hinzugegeben. Man erhitzt unter Rühren über Nacht auf 120 °C. Nach Abkühlen auf Raumtemperatur wird der entstandene Feststoff abgesaugt und mit Wasser, Methanol, Ether und Hexan so lange gewaschen bis das jeweilige Filtrat klar abläuft. Nach säulenchromatographischer Aufreinigung an Kieselgel (Eluent: Dichlormethan) erhält man den Komplex. Nach Hochvakuumsublimation ($p = 10^{-5}$ mbar, T = 350-389 °C) beträgt die Ausbeute 82-86 % d.Th. bei einer Reinheit von ca. 99.8 %.

Analog werden folgende Verbindungen erhalten:

| Bsp. | Edukt 1 | Edukt 2 | Produkt | Ausbeute |
|---|---|---|---|---|
| B1 | 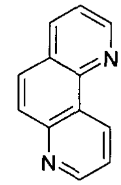 [230-46-6] | 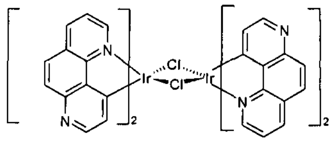 | 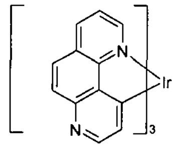 | 66% |
| B2 | 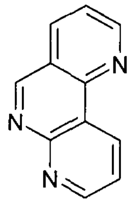 [230-53-5] | 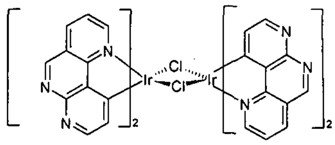 | 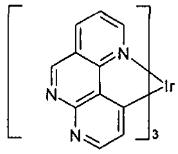 | 75% |
| B3 | 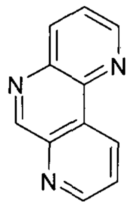 [230-49-9] | 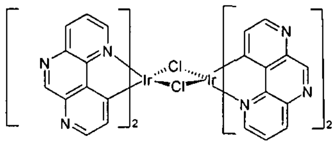 | 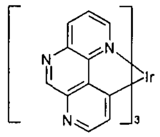 | 57% |
| B4 | 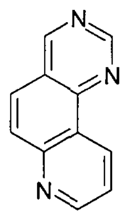 [230-48-8] | 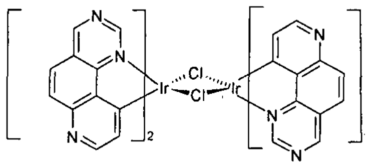 | 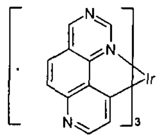 | 52% |
| B5 | 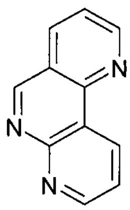 | 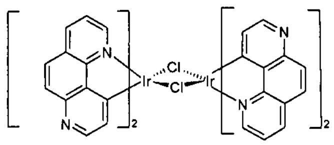 | 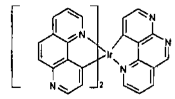 | 51% |

Der folgende Metallkomplex V1 (auch Ref2) wird als Vergleichsverbindung verwendet. V1 wird gemäß Inorg. Chem. 2001, Vol 40, 1704 synthesiert.

| Bsp. | |
|---|---|
| V1 (Ref2) | 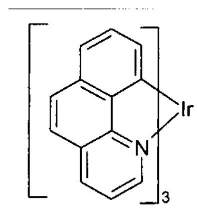 [337526-98-4] |

**C) Allgemeine Synthese heteroleptischer Komplexe mit acac: $(L)_2Ir(acac)$**

Ein Gemisch aus 1.0 mmol Iridium(III)chlorid Hydrat, 2.2 mmol Ligand, 10 ml 2-Ethoxyethanol und 0.3 ml Wasser wird 24 h unter Rückfluss bei 120 °C erhitzt. Die Reaktionsmischung wird im Vakuum eingeengt, der braune Rückstand wird in einem Gemisch aus 200 ml Wasser und 100 ml Ethanol aufgenommen und 1 h bei 60 °C ausgerührt. Der Feststoff wird abgesaugt und dreimal mit je 100 ml Ethanol gewaschen. Der braune Feststoff wird dann in 15 ml Ethoxyethanol suspendiert, mit 2.0 mmol Acetylaceton und 5.0 mmol Natriumcarbonat versetzt und 16 h unter Rückfluss erhitzt. Nach Erkalten wird der Niederschlag abgesaugt, dreimal mit je 10 ml eines Gemischs aus Ethanol / Wasser (1:1, v:v) und dann dreimal mit 10 ml Ethanol gewaschen. Nach Hochvakuumsublimation ($p = 10^{-5}$ mbar, T = 350 °C-389 °C) beträgt die Ausbeute bis zu 89% d.Th bei einer Reinheit von ca. 99.8 %.

Analog werden folgende Verbindungen erhalten:

| Bsp. | Edukt 1 | Edukt 2 | Produkt | Ausbeute |
|---|---|---|---|---|
| C1 | 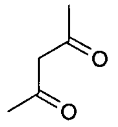 | 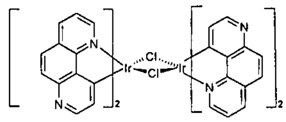 | 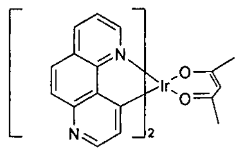 | 57% |
| C2 | 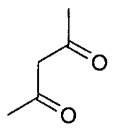 | 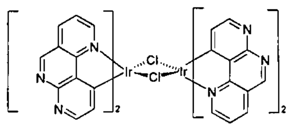 | 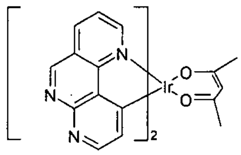 | 56 % |
| C3 | 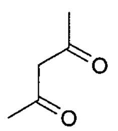 | 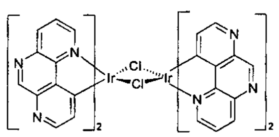 | 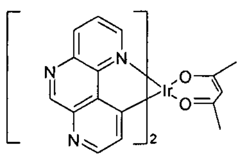 | 49% |
| C4 | 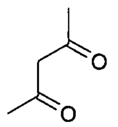 | 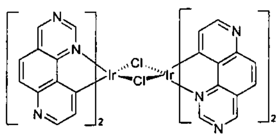 | 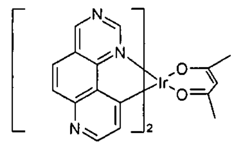 | 52 % |

Der folgende Metallkomplex Ref3 wird als Vergleichsverbindung verwendet.

| Ref3 | 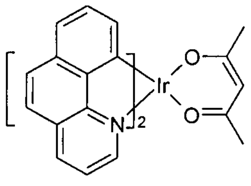 |
|---|---|

**Beispiel 2: Quantenchemische Simulationen zu B1-B5, C1-C4, und Ref1-Ref3**

Das Triplett- und Singulett-Niveau sowie die HOMO- und LUMO-Lagen der organischen Verbindungen werden über quantenchemische Rechnungen bestimmt. Hierzu wird das Programmpaket "Gaussian03W" (Gaussian Inc.) verwendet. Zur Berechnung organischer Substanzen ohne Metalle wird zuerst eine Geometrieoptimierung mit einer semiempirischen Methode "Ground State/Semi-empirical/ Default Spin/AM1" (Charge 0/Spin Singlet) durchgeführt. Im Anschluss erfolgt auf Grundlage der optimierten Geometrie eine Energierechnung. Hierbei wird die Methode "TD-SCF/DFT/ Default Spin/B3PW91" mit dem Basissatz "6-31G(d)" verwendet (Charge 0/Spin Singlet). Für metallorganische Verbindungen wird die Geometrie über die Methode "Ground State/Hartree-Fock/Default Spin/LanL2MB" (Charge 0/Spin Singlet) optimiert. Die Energierechnung erfolgt analog zu den organischen Substanzen wie oben beschrieben mit dem Unterschied, dass für das Metallatom der Basissatz "LanL2DZ" (pseudo=LanL2) und für die Liganden der Basissatz

"6-31G(d)" verwendet wird. Die wichtigsten Ergebnisse sind HOMO / LUMO-Niveaus und Energien für die Triplett- und Singulett-angeregten Zuständen. Der erste angeregte Triplettzustand und der erste angeregte Singulettzustand sind am wichtigsten. Diese Zustände werden als T1 und S1 bezeichnet. Aus der Energierechnung erhält man das HOMO HEh bzw. LUMO LEh in Hartree-Einheiten. Daraus werden die HOMO- und LUMO-Werte in Elektronenvolt wie folgt bestimmt, wobei sich diese Beziehungen aus der Kalibrierung anhand von Cyclovoltammetriemessungen ergeben:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als energetische Lage des HOMO-Niveaus bzw. des LUMO-Niveaus der Materialien anzusehen. Als Beispiel erhält man für die Verbindung B1 (siehe auch Tabelle 1) aus der Rechnung ein HOMO von -0.20972 Hartrees und ein LUMO von -0.06756 Hartrees, was einem kalibrierten HOMO von -5.98 eV und einem kalibrierten LUMO von -2.77 eV entspricht.

Die simulierten Energieniveaus der erfindungsgemäßen Metallkomplexe B1-B5 und C1-C4 sind in Tabelle 1 im Vergleich zu Ref2 und Ref3 zusammengefasst, wobei die Werte für den literaturbekannten hellblauen Emitter Ref1 als zusätzliche Referenz auch mit angegeben sind. Im Vergleich zu Ref1 liefern alle B1-B5 größere oder zumindest vergleichbare T1-Niveaus. Diese Verbindungen eignen sich daher als blau oder sogar als tiefblaue Triplettemitter. Insbesondere hat B3 sogar ein T1 Niveau von mehr als 2.9 eV. Alle B1-B5 haben ein T1 Niveau von mindestens 0.14 eV höher als Ref2.

Auch C1-C4 haben ein T1 Niveau, das deutlich höher ist als das von Ref3.

Tabelle 1: Zusammenfassung der Energieniveaus von B1 bis B5, C1 bis C4 und Ref1-Ref3

| Verbindung | Homo Corr. [eV] | Lumo Corr. [eV] | Singulett S1 [eV] | Triplett T1 [eV] |
|---|---|---|---|---|
| Ref1 | -5.90 | -2.80 | 2.97 | 2.78 |
| B1 | -5.98 | -2.77 | 3.02 | 2.78 |
| B2 | -6.32 | -3.17 | 2.89 | 2.77 |
| B3 | -6.37 | -3.05 | 3.11 | 2.91 |
| B4 | -6.39 | -3.11 | 3.03 | 2.81 |
| B5 | -6.09 | -3.02 | 2.86 | 2.75 |
| Ref2 | -5.33 | -2.51 | 2.69 | 2.61 |
| Ref3 | -5.23 | -2.57 | 2.64 | 2.44 |
| C1 | -5.78 | -2.76 | 2.84 | 2.72 |
| C2 | -6.03 | -3.10 | 2.70 | 2.63 |
| C3 | -6.07 | -2.98 | 2.88 | 2.79 |
| C4 | -6.08 | -3.06 | 2.78 | 2.67 |

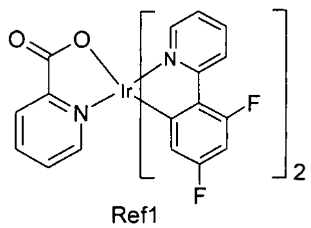

Ref1

Um die Vorteile von erfindungsgemäßem Metallkomplexe noch deutlicher zu sehen, wurden noch weitere Verbindungen simuliert.

Figur 1 zeigt das T1- und S1-Niveau verschiedener Metallkomplexe, wobei die Brücke -Y- gleich -HC=CH- ist

und die Kohlenstoffatome im Liganden durch 0, 1 oder 2 N-Atome ersetzt sind. Bx entspricht einem erfindungsgemäßen Metallkomplex und Vx dem vergleichbaren Metallkomplex gemäß dem Stand der Technik. Es wird deutlich, dass die erfindungsgemäßen Metallkomplexe ein deutlich höheres T1-Niveau haben als die vergleichbaren Metallkomplexe, wie zum Beispiel B1 im Vergleich zu V1 bis V7, B2, B3 und B4 im Vergleich zu V8 bis V10 und B6 im Vergleich zu V10.

Figur 2 zeigt das T1- und S1-Niveau verschiedener Metallkomplexe, wobei die Brücke -Y- eine Ketogruppe enthält und die Kohlenstoffatome im Liganden durch 0 oder 1 N-Atome ersetzt sind. Es wird deutlich, dass die erfindungsgemäßen Metallkomplexe ein deutlich höheres T1-Niveau haben als die vergleichbaren Metallkomplexe, wie zum Beispiel B7 im Vergleich zu V15, B8 im Vergleich zu V11 und V14 und B9 im Vergleich zu V12 und V13. Weiterhin zeigt auch der erfindungsgemäße Metallkomplex B10 ein vielversprechendes T1-Niveau.

Figur 3 zeigt das T1- und S1-Niveau verschiedener Metallkomplexe, wobei die Brücke -Y- gleich $-C(CH_3)_2-C(CH_3)_2-$ ist und die Kohlenstoffatome im Liganden durch 0 oder 1 N-Atom ersetzt sind. Es wird deutlich, dass die erfindungsgemäßen Metallkomplexe ein deutlich höheres T1-Niveau haben als die vergleichbaren Metallkomplexe, wie zum Beispiel B11 im Vergleich zu V16 bis V19. Weiterhin zeigt der erfindungsgemäße Metallkomplex B12 ein vielversprechendes T1-Niveau.

**Beispiel 3: Photolumineszenz-Untersuchungen**

Die Photolumineszenzspektren der erfindungsgemäßen Metallkomplexe B1-B4 und der Vergleichsverbindung V1 werden in einer Lösung von Toluol in einer Konzentration von ca. 0.1 mol% gemessen. Die Anregungswellenlänge ist immer das Maximum der Absorption. Aus dem Photolumineszenzspektrum werden die CIE-Koordinaten berechnet, welche in Tabelle 2 zusammengefasst sind. Die Verbindung B3 zeigt blaue Emission mit den tiefesten Farbkoordinaten (CIE y = 0.22), gefolgt von B4 mit CIE y = 0.27.

**Tabelle 2**

| | CIEx | CIEy |
|---|---|---|
| B1 | 0.15 | 0.32 |
| B2 | 0.16 | 0.30 |
| B3 | 0.16 | 0.22 |
| B4 | 0.17 | 0.27 |
| V1 | 0.44 | 0.54 |

**Beispiel 4: Lösungen und Zusammensetzungen enthaltend B1, V1 und Matrixmaterialien**

Zur Verwendung in organischen elektronischen Vorrichtungen werden Formulierungen, insbesondere Lösungen, enthaltend die erfindungsgemäßen Verbindungen hergestellt. Hierfür wird B1 als blauer Emitter für eine organische Elektrolumineszenzvorrichtung verwendet. Um eine phosphoreszierende Elektrolumineszenzvorrichtung zu bauen, werden zusätzlich ein oder mehrere Matrixmaterialien verwendet. Das Matrixmaterial sollte ein T1-Niveau höher als das des Emitters besetzen.

Die folgenden Triplettmatrixmaterialien TMM1 und TMM2 werden als Co-Matrixmaterialien verwendet. TMM1 wird gemäß WO 2005/003253 A2 und TMM2 gemäß WO 2009/124627 synthesiert.

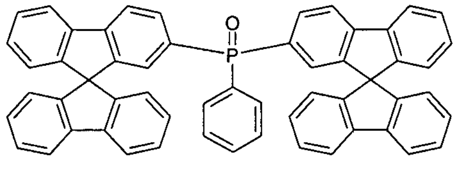

TMM1

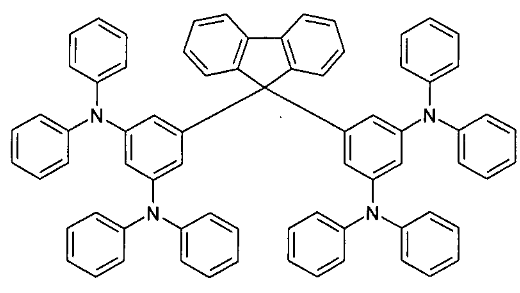

TMM2

Die Energieniveaus der Komponenten in den Mischungen sind in Tabelle 3 zusammengefasst.

**Tabelle 3: Zusammenfassung der Energieniveaus von B1, V1, TMM1 und TMM2.**

| | Homo Corr. [eV] | Lumo Corr. [eV] | Singulett S1 [eV] | Triplett T1 [eV] |
|---|---|---|---|---|
| B1 | -5.98 | -2.77 | 3.02 | 2.78 |
| V1 | -5.33 | -2.51 | 2.69 | 2.61 |
| TMM1 | -5.99 | -2.47 | 3.80 | 2.86 |
| TMM2 | -5.23 | -2.13 | 3.04 | 2.82 |

Lösungen werden wie folgt hergestellt: Zunächst werden 150 mg der Mischung nach Tabelle 4 in 10 mL Chlorbenzol gelöst und so lange gerührt, bis die Lösung klar ist. Die Lösung wird filtriert unter Verwendung eines Filters Millipore Millex LS, Hydrophobic PTFE 5.0 μm. Lösung 2 wird als Vergleich verwendet. Polystrol (PS) (von Fluka mit Mw 200.000 kg/mol) wird dazu gemischt, um eine bessere Schichtbildung zu bekommen.

**Tabelle 4: Zusammensetzung der Lösungen**

| | Zusammensetzung | Verhältnis (bezogen auf Gewicht) | Lösemittel | Konzentration |
|---|---|---|---|---|
| Lösung 1 (für OLED1) | TMM1 + TMM2+ B1+PS | 40% : 15%:15%:30% | Chlorbenzol | 15 mg/ml |
| Lösung 2 (für OLED2) | TMM1 + TMM2+ V1+PS | 40% : 15%:15%:30% | Chlorbenzol | 15 mg/ml |

Lösungen 1 und 2 werden verwendet, um die emittierende Schicht von OLEDs zu beschichten. Die entsprechende Feststoffzusammensetzung kann erhalten werden, indem das Lösemittel der Lösungen verdampft wird. Diese kann für die Herstellung weiterer Formulierungen verwendet werden.

**Beispiel 5: Herstellung der OLEDs aus Lösungen**

OLED1 und OLED2 mit einer Struktur gemäß dem Stand der Technik ITO/PEDOT/Interlayer/EML/Kathode werden unter Verwendung der entsprechenden Lösungen, wie in Tabelle 4 zusammengefasst, gemäß der folgenden Vorschrift hergestellt:

1) Beschichtung von 80 nm PEDOT (Baytron P Al 4083) auf ein ITO-beschichtetet Glassubstrat durch Spin-Coating in Reinraum, und dann Ausheizen der PEDOT Schicht bei 180°C für 10 min.
2) Beschichtung einer 20 nm Interlayer durch Spin-Coating einer Toluollösung von HIL-012 (Merck KGaA) in Konzentration von 0.5 Gew.% in einer Glovebox.
3) Ausheizen der Interlayer HIL-012 bei 180 °C für 1 h in einer Glovebox.
4) Beschichtung einer 80 nm emittierenden Schicht durch Spin-Coating einer Lösung gemäß Tabelle 4.
5) Ausheizen der Vorrichtung bei 120°C für 30 min.
6) Aufdampfen einer Ba/Al-Kathode (3 nm + 150 nm).
7) Verkapselung der Vorrichtung.

**Beispiel 6: Messungen und Vergleich der Ergebnisse von OLED1 und OLED2**

Die so erhaltenen OLEDs werden nach Standardmethoden charakterisiert. Dabei werden die folgenden Eigenschaften gemessen: UIL-Charakteristik, Elektrolumineszenzspektrum, Farbkoordinaten, Effizienz, Betriebsspannung und Lebensdauer. Die Ergebnisse sind in Tabelle 5 zusammengefasst, wobei OLED2 als Vergleich gemäß dem Stand der Technik dient. In Tabelle 5 steht EQE für die externe Quanteneffizienz, U(100) für die Spannung bei 100 cd/$m^2$ und U(1000) für die Spannung bei 1000 cd/$m^2$.

**Tabelle 5: Messergebnisse mit OLED1 und OLED2**

| | Max. Eff. [cd/A] | U(100) [V] | U(1000) [V] | CIE @ 100 cd/$m^2$ | EQE [%] |
|---|---|---|---|---|---|
| OLED1 | 5.2 | 7.4 | 9.1 | 0.16/0.37 | 2.25 |
| OLED2 (Vgl.) | 5.3 | 9.2 | 11 | 0.45/0.56 | 1.82 |

Wie aus Tabelle 5 ersichtlich ist, wird unter Verwendung des erfindungsgemäßen Emitters B1 eine verbesserte phosphoreszierende OLED in Bezug auf Farbe und Effizienz, insbesondere auf die Farbe, erhalten.

**Beispiel 7: Herstellung von OLEDs durch Bedampfen**

Die Herstellung durch Bedampfen von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen (siehe Tabellen 6 und 7) werden die Ergebnisse verschiedener OLEDs vorgestellt. Glasplättchen, die mit strukturiertem ITO (Indium Zinn Oxid) der Dicke 50 nm beschichtet sind, werden zur verbesserten Prozessierung mit 80 nm PEDOT beschichtet (Poly(3,4-ethylendioxy-2,5-thiophen), aus Wasser aufgeschleudert; bezogen von H. C. Starck, Goslar, Deutschland). Diese beschichteten Glasplättchen bilden die Substrate, auf welche die OLEDs aufgebracht werden. Die OLEDs haben prinzipiell folgenden Schichtaufbau: Substrat / optionale Lochinjektionsschicht (HIL1) / optionale Lochinjektionsschicht (HIL2) / Lochtransportschicht (HTL) / Elektronenblockerschicht (EBL) / Emissionsschicht (EML) / optionale Lochblockierschicht (HBL) / Elektronentransportschicht (ETL) und abschließend eine Kathode. Die Kathode wird durch eine 100 nm dicke Aluminiumschicht gebildet

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie TMM1:TMM2:B1 (80%:10%:10%) bedeutet hierbei, dass das Material TMM1 in einem Volumenanteil von 80%, TMM2 in einem Anteil von 10% und B1 in einem Anteil von 10% in der Schicht vorliegt. Analog kann auch die Elektronentransportschicht aus einer Mischung zweier Materialien bestehen. Der genaue Aufbau der OLEDs ist Tabelle 6 zu entnehmen. Ausser TMM1 und TMM2 sind die zur Herstellung der OLEDs verwendeten Materialien in Tabelle 8 gezeigt.

Die OLEDs werden standardmäßig charakterisiert. Hierfür werden die Elektrolumineszenzspektren, die Stromeffizienz (gemessen in cd/A), die EQE und die Spannung (gemessen bei 1000 cd/$m^2$ in V) bestimmt aus Strom-Spannungs-Helligkeits-Kennlinien (IUL-Kennlinien).

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Verbindungen Ref2 und Ref3 verwendet. Die Ergebnisse der OLEDs sind in Tabelle 7 zusammengefasst.

Tabelle 6: Aufbau der OLEDs

| Bsp. | HIL1 Dicke | HIL2 Dicke | EBL Dicke | EML Dicke | HBL Dicke | ETL Dicke |
|---|---|---|---|---|---|---|
| Ref2 | HTM1 20 nm | EBM1 5m | EBM2 15 nm | TMM1:TMM2:Ref2 (70%:20%:10%) 40 nm | HBM1 10 nm | ETM1:LiQ (50%:50%) 30 nm |
| Ref3 | HTM1 20 nm | EBM1 5 m | EBM2 15 nm | TMM1:TMM2:Ref3 (70%:20%:10%) 40 nm | HBM1 10 nm | ETM1: LiQ (50%:50%) 30 nm |
| B1 | HTM1 20 nm | EBM1 5m | EBM2 15 nm | TMM1:TMM2:B1 (70%:20%:10%) 40 nm | HBM1 10 nm | ETM1:LiQ (50%:50%) 30 nm |
| B2 | HTM1 20 nm | EBM1 5 m | EBM2 15 nm | TMM1:TMM2:B2 (70%:20%:10%) 40 nm | HBM1 10 nm | ETM1: LiQ (50%:50%) 30 nm |
| B3 | HTM1 20 nm | EBM1 5m | EBM2 15 nm | TMM1:TMM2:B3 (70%:20%:10%) 40 nm | HBM1 10 nm | ETM1:LiQ (50%:50%) 30 nm |
| B4 | HTM1 20 nm | EBM1 5 m | EBM2 15 nm | TMM1:TMM2:B4 (70%:20%:10%) 40 nm | HBM1 10 nm | ETM1:LiQ (50%:50%) 30 nm |
| B5 | HTM1 20 nm | EBM1 5m | EBM2 15 nm | TMM1:TMM2:B5 (70%:20%:10%) 40 nm | HBM1 10 nm | ETM1:LiQ (50%:50%) 30 nm |
| C1 | HTM1 20 nm | EBM1 5m | EBM2 15 nm | TMM1:TMM2:C1 (70%:20%:10%) 40 nm | HBM1 10 nm | ETM1:LiQ (50%:50%) 30 nm |
| C2 | HTM1 20 nm | EBM1 5m | EBM2 15 nm | TMM1:TMM2:C2 (70%:20%:10%) 40 nm | HBM1 10 nm | ETM1:LiQ (50%:50%) 30 nm |

(fortgesetzt)

| Bsp. | HIL1 Dicke | HIL2 Dicke | EBL Dicke | EML Dicke | HBL Dicke | ETL Dicke |
|---|---|---|---|---|---|---|
| C3 | HTM1 20 nm | EBM1 5 m | EBM2 15 nm | TMM1:TMM2:C3 (70%:20%:10%) 40 nm | HBM1 10 nm | ETM1:LiQ (50%:50%) 30 nm |
| C4 | HTM1 20 nm | EBM1 5 m | EBM2 15 nm | TMM1:TMM2:C4 (70%:20%:10%) 40 nm | HBM1 10 nm | ETM1:LiQ (50%:50%) 30 nm |

Tabelle 7: Verwendung von erfindungsgemäßen Verbindungen als phosphoreszierende Emittermaterialien in phosphoreszenten OLEDs

| Bsp. | Spannung (V) 1000 cd/m$^2$ | Effizienz (cd/A) bei 1000 cd/m$^2$ | CIE x/y bei 1000 cd/m$^2$ | EQE bei 1000 cd/m$^2$ |
|---|---|---|---|---|
| Ref2 | 6.0 | 22.0 | 0.34/0.62 | 9.3 % |
| Ref3 | 6.1 | 23.0 | 0.38/0.59 | 6.5 % |
| B1 | 7.7 | 6.7 | 0.15/0.20 | 4.8 % |
| B2 | 6.6 | 14.7 | 0.15/0.27 | 8.1 % |
| B3 | 8.1 | 5.9 | 0.15/0.19 | 4.3 % |
| B4 | 7.9 | 8.2 | 0.16/0.21 | 5.8 % |
| B5 | 6.5 | 18.0 | 0.15/0.30 | 9.6 % |
| C1 | 4.3 | 36.3 | 0.36/0.61 | 9.7 % |
| C2 | 5.7 | 34.0 | 0.34/0.62 | 9.3 % |
| C3 | 6.1 | 10.5 | 0.16/0.27 | 5.7 % |
| C4 | 5.7 | 32.0 | 0.32/0.63 | 8.9 % |

Tabelle 8: Strukturformeln der verwendeten Materialien

| | |
|---|---|
| 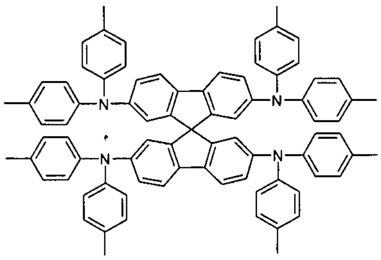 | 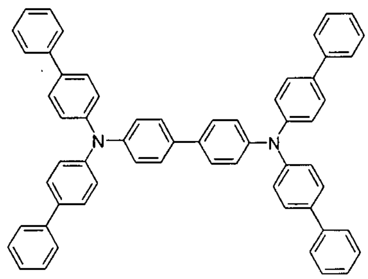 |
| HTM1 | EBM1 |
| 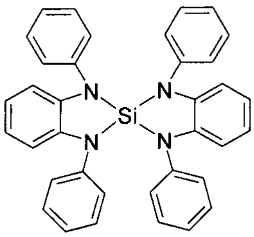 | 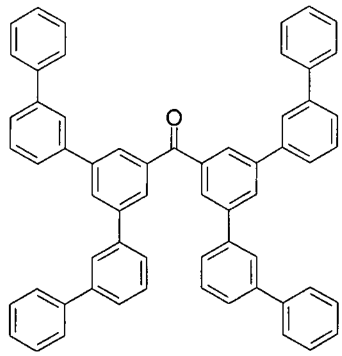 |

(fortgesetzt)

| EBM2 | HBM1 |
|---|---|
| 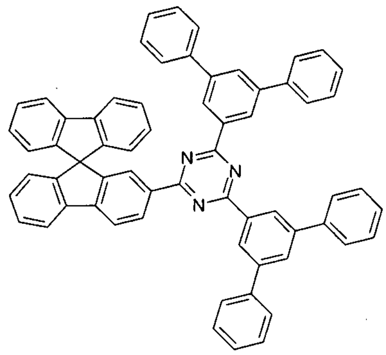 | 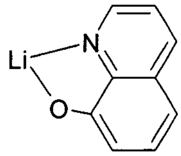 |
| ETM1 | LiQ |

Auf der Grundlage der vorliegenden erfindungsgemäßen technischen Lehre können weitere Optimierungen mittels unterschiedlicher Möglichkeiten realisiert werden, ohne dabei erfinderisch tätig zu sein. So kann eine weitere Optimierung beispielsweise durch die Verwendung einer anderen Matrix oder gemischter Matrizes in der gleichen oder einer anderen Konzentration oder durch andere Interlayer-Materialien erreicht werden.

## Patentansprüche

1. Verbindung gemäß Formel (1),

$$[M(L)_n(L')_m]_w^{x+/x-}\,[A]_y^{z-/z+} \qquad \text{Formel (1)}$$

wobei die Verbindung der allgemeinen Formel (1) eine Teilstruktur M(L)n der Formel (2) enthält:

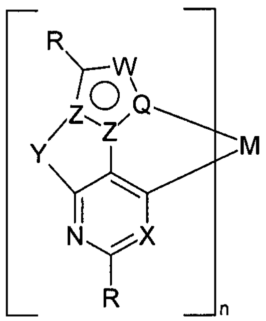

Formel (2)

wobei für die verwendeten Symbole und Indizes gilt:

M ist Iridium;
Q ist bei jedem Auftreten N;
X ist bei jedem Auftreten gleich oder verschieden CR oder N;
Y ist bei jedem Auftreten gleich oder verschieden eine substituierte oder unsubstituierte zweiatomige Brücke enthaltend als Brückenatome zwei Atome, gleich oder verschieden bei jedem Auftreten ausgewählt aus der Gruppe bestehend aus C, N, O, S, Si oder P;
W ist bei jedem Auftreten gleich oder verschieden CR=CR oder CR=N;
Z ist C;
R ist bei jedem Auftreten gleich oder verschieden H, D, F, Cl, Br, I, $N(R^1)_2$, CN, $NO_2$, OH, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, eine geradkettige Alkyl-, Alkoxy- oder

Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^1$ substituiert sein kann, wobei eine oder mehrere nicht benachbarte $CH_2$-Gruppen durch $R^1C{=}CR^1$, C=C, $Si(R^1)_2$, C=O, $NR^1$, O, S oder $CONR^1$ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 40 aromatischen Ringatomen, die durch einen oder mehrere Reste $R^1$ substituiert sein kann, oder eine Aralkyl- oder Heteroaralkylgruppe mit 5 bis 40 aromatischen Ringatomen, die durch einen oder mehrere Reste $R^1$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^1$ substituiert sein kann; dabei können zwei benachbarte Reste R auch miteinander ein mono- oder polycyclisches, aliphatisches, aromatisches oder heteroaromatisches Ringsystem bilden;

$R^1$ ist bei jedem Auftreten gleich oder verschieden H, D, F, Cl, Br, I, $N(R^2)_2$, CN, $NO_2$, $Si(R^2)_3$, $B(OR^2)_2$, $C(=O)R^2$, $P(=O)(R^2)$ $S(=O)R^2$, $S(=O)_2R^2$, $OSO_2R^2$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^2$ substituiert sein kann, wobei eine oder mehrere nicht benachbarte $CH_2$-Gruppen durch $R^2C{=}_{CR}{}^2$, C=C, $Si(R^2)_2$, C=O, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 40 aromatischen Ringatomen, die durch einen oder mehrere Reste $R^2$ substituiert sein kann, oder eine Aralkyl- oder Heteroaralkylgruppe mit 5 bis 40 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann; dabei können zwei oder mehrere benachbarte Reste $R^2$ miteinander ein mono- oder polycyclisches, aliphatisches Ringsystem bilden;

$R^2$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^2$ auch miteinander ein mono- oder polycyclisches, aliphatisches Ringsystem bilden;

L' ist gleich oder verschieden bei jedem Auftreten ein beliebiger Coligand;

A ist ein Gegenion;

n ist 1, 2 oder 3;

m ist 0, 1, 2, 3 oder 4;

w ist 1, 2 oder 3;

x, y, z sind bei jedem Auftreten gleich oder verschieden 0, 1, 2 oder 3; dabei gilt, dass $(w \cdot x) = (y \cdot z)$;

dabei können auch mehrere Liganden L miteinander oder L mit L' über eine beliebige Brücke V verknüpft sein und so ein tridentates, tetradentates, pentadentates oder hexadentates Ligandensystem aufspannen;
weiterhin kann auch ein Substituent R zusätzlich an das Metall koordinieren.

2. Verbindung nach Anspruch 1, **dadurch gekennzeichnet, dass** in der Gruppe Y eines der beiden Brückenatome ein Kohlenstoffatom darstellt und dass das andere Brückenatom bevorzugt ausgewählt ist aus C, N oder O, wobei die Atome jeweils durch Reste R substituiert sein können.

3. Verbindung nach Anspruch 1 oder 2, **dadurch gekennzeichnet, dass** die Brücke Y ausgewählt ist aus den Strukturen -CR=CR-, -CR=N-, $-C(=O)-CR_2-$, -C(=O)-NR-, -C(=O)-O- oder $-CR_2-CR_2-$ oder aus den Strukturen gemäß den Formeln (A) bis (E),

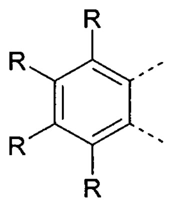
Formel (A)

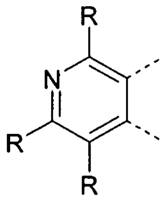
Formel (B)

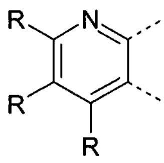
Formel (C)

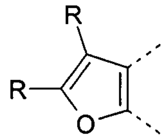
Formel (D)

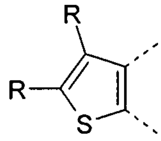
Formel (E)

wobei R die in Anspruch 1 genannte Bedeutung aufweist und die gestrichelten Bindungen jeweils die Bindung dieser Gruppe im entsprechenden Liganden andeuten.

4. Verbindung nach einem oder mehreren der Ansprüche 1 bis 3, **dadurch gekennzeichnet, dass** die Teilstruktur gemäß Formel (2) ausgewählt ist aus den Strukturen der folgenden Formeln (8) bis (10),

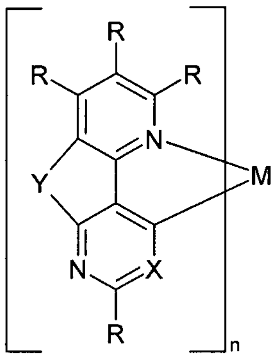
Formel (8)

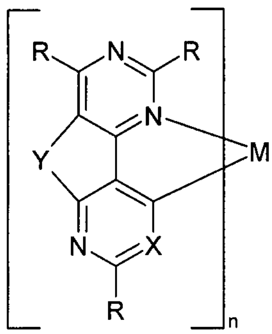
Formel (9)

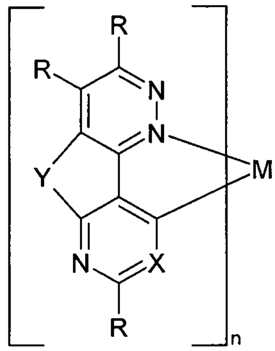
Formel (10) ,

wobei die verwendeten Symbole und Indizes die in Anspruch 1 genannten Bedeutungen aufweisen.

5. Verbindung nach einem oder mehreren der Ansprüche 1 bis 4, **dadurch gekennzeichnet, dass** X für CR und bevorzugt für CH steht.

6. Verbindung nach einem oder mehreren der Ansprüche 1 bis 5, **dadurch gekennzeichnet, dass** der Substituent R, der in ortho-Position zur Metallkoordination steht, eine Gruppe darstellt, die ebenfalls an das Metall M koordiniert.

7. Verbindung nach einem oder mehreren der Ansprüche 1 bis 6, ausgewählt aus den Verbindungen der folgenden Formeln (19) und (20),

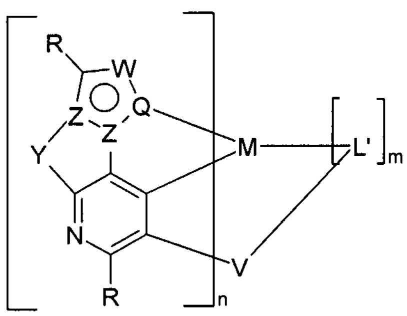
Formel (19)

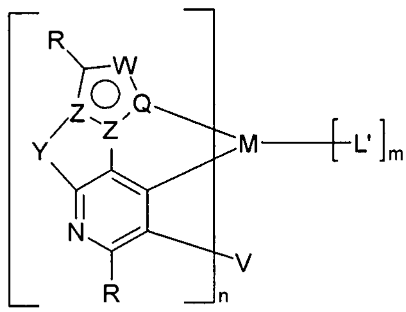
Formel (20)

wobei die verwendeten Symbole die in Anspruch 1 genannten Bedeutungen aufweisen, wobei V eine verbrückende Einheit darstellt, enthaltend 1 bis 80 Atome aus der dritten, vierten, fünften und/oder sechsten Hauptgruppe oder einen 3- bis 6-gliedrigen Homo- oder Heterocyclus, die die Teilliganden L miteinander oder L mit L' miteinander

kovalent verbindet.

**8.** Verbindung nach einem oder mehreren der Ansprüche 1 bis 7, **dadurch gekennzeichnet, dass** L' gleich oder verschieden bei jedem Auftreten ausgewählt ist aus der Gruppe bestehend aus Kohlenmonoxid, Stickstoffmonoxid, Alkylcyaniden, Arylcyaniden, Alkylisocyaniden, Arylisocyaniden, Aminen, Phosphinen, Phosphiten, Arsinen, Stibinen, stickstoffhaltigen Heterocyclen, Carbenen, Hydrid, Deuterid, den Halogeniden $F^-$, $Cl^-$, $Br^-$ und $I^-$, Alkylacetyliden, Arylacetyliden, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten, Arylgruppen, $O^{2-}$, $S^{2-}$, Carbiden, Nitrenen, $N^{3-}$, Diaminen, Iminen, Diiminen, Diphosphinen, 1,3-Diketonaten 3-Ketonaten, Salicyliminaten Dialkoholaten, Dithiolaten, Boraten stickstoffhaltiger Heterocyclen, $\eta^5$-Cyclopentadienyl, $\eta^5$-Pentamethylcyclopentadienyl, $\eta^6$-Benzol oder $\eta^7$-Cycloheptatrienyl, welche jeweils durch einen oder mehrere Reste R substituiert sein können, oder Liganden, welche mit dem Metall einen cyclometallierten Fünfring oder Sechsring mit mindestens einer Metall-Kohlenstoff-Bindung aufweisen.

**9.** Verfahren zur Herstellung einer Verbindung nach einem oder mehreren der Ansprüche 1 bis 8 durch Umsetzung des Liganden mit Metallalkoholaten der Formel (64), mit Metallketoketonaten der Formel (65), mit Metallhalogeniden der Formel (66) oder mit dimeren Metallkomplexen der Formel (67),

$M(OR)_n$

Formel (64)

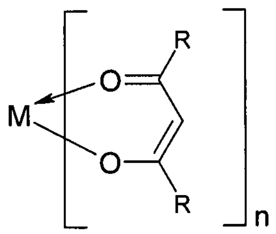

Formel (65)

$MHal_n$

Formel (66)

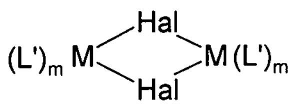

Formel (67)

wobei die Symbole M, m, n und R die in Anspruch 1 angegebenen Bedeutungen haben und Hal = F, Cl, Br oder I ist.

**10.** Formulierung, insbesondere eine Lösung, eine Dispersion oder eine Miniemulsion, enthaltend mindestens eine Verbindung nach einem oder mehreren der Ansprüche 1 bis 8 und mindestens ein Lösemittel.

**11.** Verwendung einer Verbindung nach einem oder mehreren der Ansprüche 1 bis 8 in einer elektronischen Vorrichtung.

**12.** Elektronische Vorrichtung, insbesondere ausgewählt aus der Gruppe bestehend aus organischen Elektrolumineszenzvorrichtungen, organischen lichtemittierenden Transistoren, organischen lichtemittierenden elektrochemischen Zellen, organischen lichtemittierenden elektrochemischen Transistoren, organischen integrierten Schaltungen, organischen Feld-Effekt-Transistoren, organischen Dünnfilmtransistoren, organischen Solarzellen, organischen optischen Detektoren, organischen Photorezeptoren, organischen Feld-Quench-Devices, Organic Plasmon Emitting Device oder organischen Laserdioden, enthaltend in mindestens einer Schicht mindestens eine Verbindung nach einem oder mehreren der Ansprüche 1 bis 8.

**13.** Elektronische Vorrichtung nach Anspruch 12, wobei es sich um eine organische Elektrolumineszenzvorrichtung oder organische lichtemittierende elektrochemische Zelle handelt, enthaltend die Verbindung nach einem oder mehreren der Ansprüche 1 bis 8 als emittierende Verbindung in einer oder mehreren emittierenden Schichten.

**14.** Verbindung nach einem oder mehreren der Ansprüche 1 bis 8 oder Formulierung nach Anspruch 10 oder Vorrichtung nach Anspruch 12 oder 13 zur Therapie, insbesondere Phototherapie, Prophylaxe und/oder Diagnose von Erkrankungen und/oder kosmetischer Umstände.

## Claims

**1.** Compound of the formula (1),

$$[M(L)_n(L')_m]_w^{x+/x-}\ [A]_y^{z-/z+}\quad \text{formula (1)}$$

where the compound of the general formula (1) contains a moiety M(L)n of the formula (2),

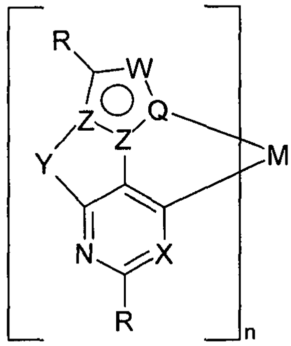

formula (2)

where the following applies to the symbols and indices used:

M is iridium;
Q is on each occurrence N;
X is on each occurrence, identically or differently, CR or N;
Y is on each occurrence, identically or differently, a substituted or unsubstituted diatomic bridge containing, as bridge atoms, two atoms selected, identically or differently on each occurrence, from the group consisting of C, N, O, S, Si or P;
W is on each occurrence, identically or differently, CR=CR or CR=N;
Z is C;
R is on each occurrence, identically or differently, H, D, F, Cl, Br, I, $N(R^1)_2$, CN, $NO_2$, OH, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals $R^1$, where one or more non-adjacent $CH_2$ groups may be replaced by $R^1C=CR^1$, C=C, $Si(R^1)_2$, C=O, $NR^1$, O, S or $CONR^1$ and where one or more H atoms may be replaced by D, F, Cl, Br, I or CN, or an aromatic or heteroaromatic ring system having 5 to 60 aromatic ring atoms, which may in each case be substituted by one or more radicals $R^1$, or an aryloxy or heteroaryloxy group having 5 to 40 aromatic ring atoms, which may be substituted by one or more radicals $R^1$, or an aralkyl or heteroaralkyl group having 5 to 40 aromatic ring atoms, which may be substituted by one or more radicals $R^1$, or a diarylamino group, diheteroarylamino group or arylheteroarylamino group having 10 to 40 aromatic ring atoms, which may be substituted by one or more radicals $R^1$; two adjacent radicals R here may also form a mono- or polycyclic, aliphatic, aromatic or heteroaromatic ring system with one another;
$R^1$ is on each occurrence, identically or differently, H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals $R^2$, where one or more non-adjacent $CH_2$ groups may be replaced by $R^2C=CR^2$, C=C, $Si(R^2)_2$, C=O, $NR^2$, O, S or $CONR^2$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^2$, or an aryloxy or heteroaryloxy group having 5 to 40 aromatic ring atoms, which may be substituted by one or more radicals $R^2$, or an aralkyl or heteroaralkyl group having 5 to 40 aromatic ring atoms, which may be substituted by one or more radicals $R^2$, or a diarylamino group, diheteroarylamino group or arylheteroarylamino group having 10 to 40 aromatic ring atoms, which may be substituted by one or more radicals $R^2$; two or more adjacent radicals $R^2$ here may form a mono- or polycyclic, aliphatic ring system with one another;
$R^2$ is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents $R^2$ here may also form a mono- or polycyclic, aliphatic ring system with one another;

L' is, identically or differently on each occurrence, any desired co-ligand;
A is a counterion;
n is 1, 2 or 3;
m is 0, 1, 2, 3 or 4;
w is 1, 2 or 3;
x, y, z are on each occurrence, identically or differently, 0, 1, 2 or 3; where (w · x) = (y · z);

a plurality of ligands L here may also be linked to one another or L may be linked to L' via any desired bridge V and thus form a tridentate, tetradentate, pentadentate or hexadentate ligand system;
furthermore, a substituent R may also additionally be coordinated to the metal.

2. Compound according to Claim 1, **characterised in that** one of the two bridge atoms in the group Y represents a carbon atom and **in that** the other bridge atom is preferably selected from C, N or O, where the atoms may in each case be substituted by radicals R.

3. Compound according to Claim 1 or 2, **characterised in that** the bridge Y is selected from the structures -CR=CR-, -CR=N-, $-C(=O)-CR_2-$, -C(=O)-NR-, -C(=O)-O- or $-CR_2-CR_2-$ or from the structures of the formulae (A) to (E),

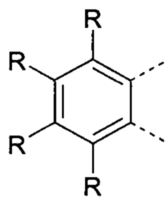
formula (A)
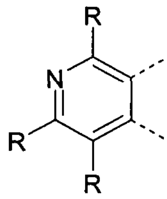
formula (B)
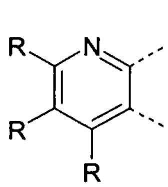
formula (C)
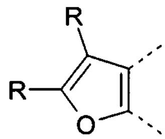
formula (D)
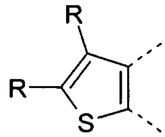
formula (E)

where R has the meaning given in Claim 1 and the dashed bonds in each case indicate the bonding of this group in the corresponding ligand.

4. Compound according to one or more of Claims 1 to 3, **characterised in that** the moiety of the formula (2) is selected from the structures of the following formulae (8) to (10),

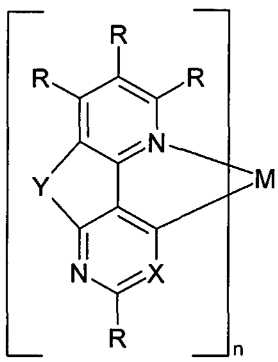
formula (8)
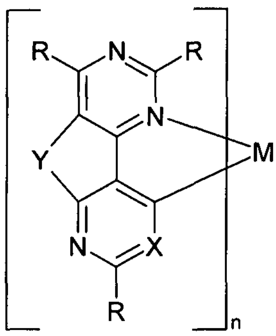
formula (9)
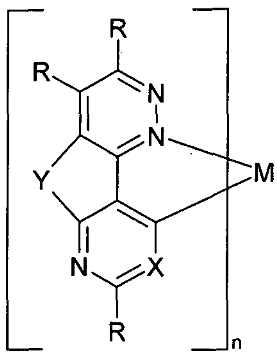
formula (10)
,

where the symbols and indices used have the meanings given in Claim 1.

5. Compound according to one or more of Claims 1 to 4, **characterised in that** X stands for CR and preferably for CH.

6. Compound according to one or more of Claims 1 to 5, **characterised in that** the substituent R in the ortho-position to the metal coordination represents a group which is likewise coordinated to the metal M.

7. Compound according to one or more of Claims 1 to 6, selected from the compounds of the following formulae (19) and (20),

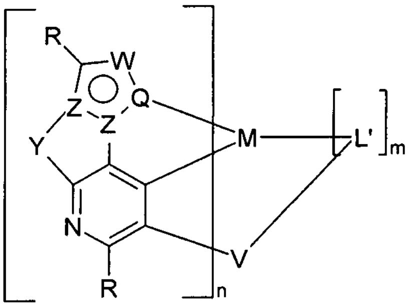

formula (19)

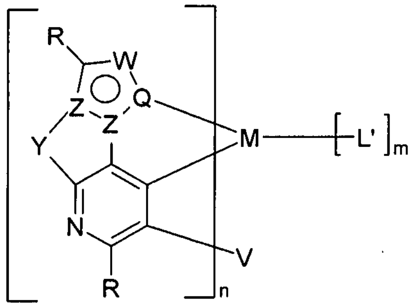

formula (20)

where the symbols used have the meanings given in Claim 1, where V represents a bridging unit containing 1 to 80 atoms from the third, fourth, fifth and/or sixth main group or a 3- to 6-membered homo- or heterocycle which covalently bonds the part-ligands L to one another or L to L'.

**8.** Compound according to one or more of Claims 1 to 7, **characterised in that** L' is selected, identically or differently on each occurrence, from the group consisting of carbon monoxide, nitrogen monoxide, alkyl-cyanides, arylcyanides, alkylisocyanides, arylisocyanides, amines, phosphines, phosphites, arsines, stibines, nitrogen-containing heterocycles, carbenes, hydride, deuteride, the halides $F^-$, $Cl^-$, $Br^-$ and $I^-$, alkylacetylides, arylacetylides, cyanide, cyanate, isocyanate, thiocyanate, isothiocyanate, aliphatic or aromatic alcoholates, aliphatic or aromatic thioalcoholates, amides, carboxylates, aryl groups, $O^{2-}$, $S^{2-}$, carbides, nitrenes, $N^{3-}$, diamines, imines, diimines, diphosphines, 1,3-diketonates, 3-ketonates, salicyliminates, dialcoholates, dithiolates, borates of nitrogen-containing heterocycles, $\eta^5$-cyclopentadienyl, $\eta^5$-pentamethylcyclopentadienyl, $\eta^6$-benzene or $\eta^7$-cycloheptatrienyl, each of which may be substituted by one or more radicals R, or ligands which have with the metal a cyclometallated five-membered ring or sixmembered ring having at least one metal-carbon bond.

**9.** Process for the preparation of a compound according to one or more of Claims 1 to 8 by reaction of the ligand with metal alkoxides of the formula (64), with metal ketoketonates of the formula (65), with metal halides of the formula (66) or with dimeric metal complexes of the formula (67),

$M(OR)_n$

formula (64)

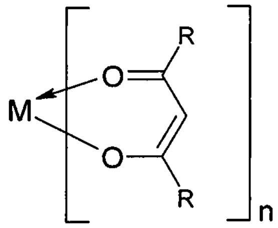

formula (65)

$MHal_n$

formula (66)

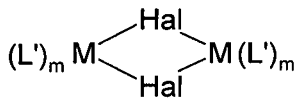

formula (67)

where the symbols M, m, n and R have the meanings indicated in Claim 1 and Hal = F, Cl, Br or I.

**10.** Formulation, in particular a solution, a dispersion or a mini-emulsion, comprising at least one compound according to one or more of Claims 1 to 8 and at least one solvent.

**11.** Use of a compound according to one or more of Claims 1 to 8 in an electronic device.

**12.** Electronic device, in particular selected from the group consisting of organic electroluminescent devices, organic light-emitting transistors, organic light-emitting electrochemical cells, organic light-emitting electrochemical transistors, organic integrated circuits, organic field-effect transistors, organic thin-film transistors, organic solar cells, organic optical detectors, organic photoreceptors, organic field-quench devices, organic plasmon emitting devices or organic laser diodes, comprising at least one compound according to one or more of Claims 1 to 8 in at least one layer.

**13.** Electronic device according to Claim 12, which is an organic electroluminescent device or organic light-emitting

electrochemical cell, comprising the compound according to one or more of Claims 1 to 8 as emitting compound in one or more emitting layers.

**14.** Compound according to one or more of Claims 1 to 8 or formulation according to Claim 10 or device according to Claim 12 or 13 for the therapy, in particular phototherapy, prophylaxis and/or diagnosis of diseases and/or cosmetic conditions.

**Revendications**

**1.** Composé de la formule (1) :

$$[M(L)_n(L')_m]_w{}^{x+/x-}\,[A]_y{}^{z-/z+} \quad \text{formule (1)}$$

dans laquelle le composé de la formule générale (1) contient une moitié $M(L)_n$ de la formule (2) :

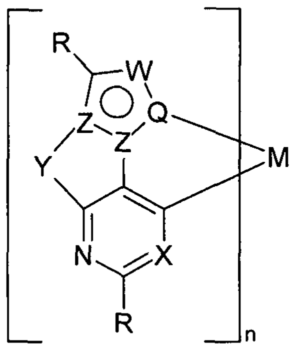

formule (2)

dans laquelle ce qui suit s'applique aux symboles et indices utilisés :

M est iridium ;
Q est, pour chaque occurrence, N ;
X est, pour chaque occurrence, de manière identique ou différente, CRouN;
Y est, pour chaque occurrence, de manière identique ou différente, un pont diatomique substitué ou non substitué contenant, en tant qu'atomes de pont, deux atomes choisis, de manière identique ou différente pour chaque occurrence, parmi le groupe constitué par C,N,O,S,Si ou P;
W est, pour chaque occurrence, de manière identique ou différente, CR=CR ou CR=N ;
Z est C ;
R est, pour chaque occurrence, de manière identique ou différente, H, D, F, Cl, Br, I, $N(R^1)_2$, CN, $NO_2$, OH, COOH, $C(=O)N(R^1)_2$, $Si(R^1)_3$, $B(OR^1)_2$, $C(=O)R^1$, $P(=O)(R^1)_2$, $S(=O)R^1$, $S(=O)_2R^1$, $OSO_2R^1$, un groupe alkyle, alcoxy ou thioalcoxy en chaîne droite comportant 1 à 20 atome(s) de C ou un groupe alkényle ou alkynyle comportant 2 à 20 atomes de C ou un groupe alkyle, alcoxy ou thioalcoxy ramifié ou cyclique comportant 3 à 20 atomes de C, dont chacun peut être substitué par un radical ou plusieurs radicaux $R^1$, où un ou plusieurs groupe(s) $CH_2$ non adjacents peut/peuvent être remplacé(s) par $R^1C=CR^1$, C≡C, $Si(R^1)_2$, C=O, $NR^1$, O, S ou $CONR^1$ et où un ou plusieurs atome(s) de H peut/ peuvent être remplacé(s) par D, F, Cl, Br, I ou CN, ou un système de cycle aromatique ou hétéroaromatique comportant 5 à 60 atomes de cycle aromatique, lequel peut dans chaque cas être substitué par un radical ou plusieurs radicaux $R^1$, ou un groupe aryloxy ou hétéroaryloxy comportant 5 à 40 atomes de cycle aromatique, lequel peut être substitué par un radical ou plusieurs radicaux $R^1$, ou un groupe aralkyle ou hétéroaralkyle comportant 5 à 40 atomes de cycle aromatique, lequel peut être substitué par un radical ou plusieurs radicaux $R^1$, ou un groupe diarylamino, un groupe dihétéroarylamino ou un groupe arylhétéroarylamino comportant 10 à 40 atomes de cycle aromatique, lequel peut être substitué par un radical ou plusieurs radicaux $R^1$ ; deux radicaux R adjacents peuvent ici également former un système de cycle aliphatique, aromatique ou hétéroaromatique monocyclique ou polycyclique l'un avec l'autre ;
$R^1$ est, pour chaque occurrence, de manière identique ou différente, H, D, F, Cl, Br, I, $N(R^2)_2$, CN, $NO_2$ $Si(R^2)_3$,

$B(OR^2)_2$, $C(=O)R^2$, $P(=O)(R^2)_2$, $S(=O)R^2$, $S(=O)_2R^2$, $OSO_2R^2$, un groupe alkyle, alcoxy ou thioalcoxy en chaîne droite comportant 1 à 20 atome(s) de C ou un groupe alkényle ou alkynyle comportant 2 à 20 atomes de C ou un groupe alkyle, alcoxy ou thioalcoxy ramifié ou cyclique comportant 3 à 20 atomes de C, dont chacun peut être substitué par un radical ou plusieurs radicaux $R^2$, où un ou plusieurs groupe(s) $CH_2$ non adjacents peut/peuvent être remplacé(s) par $R^2C=CR^2$, C=C, $Si(R^2)_2$, C=O, $NR^2$, O, S ou $CONR^2$ et où un ou plusieurs atome(s) de H peut/peuvent être remplacé(s) par D, F, Cl, Br, I, CN ou $NO_2$, ou un système de cycle aromatique ou hétéroaromatique comportant 5 à 60 atomes de cycle aromatique, lequel peut dans chaque cas être substitué par un radical ou plusieurs radicaux $R^2$, ou un groupe aryloxy ou hétéroaryloxy comportant 5 à 40 atomes de cycle aromatique, lequel peut être substitué par un radical ou plusieurs radicaux $R^2$, ou un groupe aralkyle ou hétéroaralkyle comportant 5 à 40 atomes de cycle aromatique, lequel peut être substitué par un radical ou plusieurs radicaux $R^2$, ou un groupe diarylamino, un groupe dihétéroarylamino ou un groupe arylhétéroarylamino comportant 10 à 40 atomes de cycle aromatique, lequel peut être substitué par un radical ou plusieurs radicaux $R^2$ ; deux radicaux adjacents $R^2$ ou plus peuvent ici également former un système de cycle aliphatique monocyclique ou polycyclique l'un avec l'autre ou les uns avec les autres ;

$R^2$ est, pour chaque occurrence, de manière identique ou différente, H, D, F ou un radical hydrocarbone aliphatique, aromatique et/ou hétéroaromatique comportant 1 à 20 atome(s) de C, où, en outre, un ou plusieurs atome(s) de H peut/peuvent être remplacé(s) par F ; deux substituants $R^2$ ou plus peuvent ici également former un système de cycle aliphatique monocyclique ou polycyclique l'un avec l'autre ou les uns avec les autres ;

L' est, de manière identique ou différente pour chaque occurrence, n'importe quel co-ligand souhaité ;

A est un contre-ion ;

n est 1, 2 ou 3 ;

m est 0, 1, 2, 3 ou 4 ;

w est 1,2 ou 3;

x, y, z sont, pour chaque occurrence, de manière identique ou différente, 0, 1, 2 ou 3 ; où $(w \cdot x) = (y \cdot z)$ ;

une pluralité de ligands L peuvent ici également être liés les uns aux autres ou L peut être lié à L' via n'importe quel pont souhaité V et ces ligands peuvent par conséquent former un système de ligands tridentates, tétradentates, pentadentates ou hexadentates ;

qui plus est, un substituant R peut également, de façon additionnelle, être coordonné avec le métal.

2. Composé selon la revendication 1, **caractérisé en ce que** l'un des deux atomes de pont dans le groupe Y représente un atome de carbone et **en ce que** l'autre atome de pont est, de façon préférable, choisi parmi C, N ou O, où les atomes peuvent, dans chaque cas, être substitués par des radicaux R.

3. Composé selon la revendication 1 ou 2, **caractérisé en ce que** le pont Y est choisi parmi les structures -CR=CR-, -CR=N-, $-C(=O)-CR_2-$, -C(=O)-NR-, -C(=O)-O- ou $-CR_2-CR_2-$ ou parmi les structures des formules (A) à (E) :

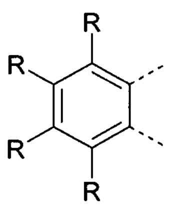
formule (A)

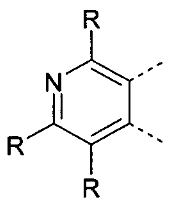
formule (B)

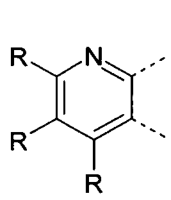
formule (C)

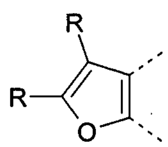
formule (D)

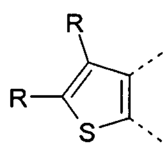
formule (E)

dans lesquelles R présente la signification donnée selon la revendication 1 et les liens en pointillés indiquent dans chaque cas le lien de ce groupe dans le ligand correspondant.

4. Composé selon une ou plusieurs des revendications 1 à 3, **caractérisé en ce que** la moitié de la formule (2) est choisie parmi les structures des formules (8) à (10) qui suivent :

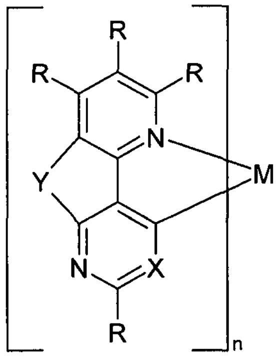

formule (8)

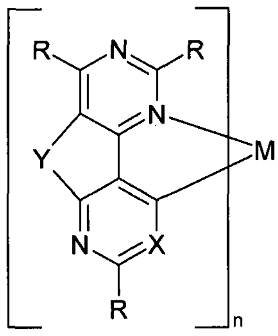

formule (9)

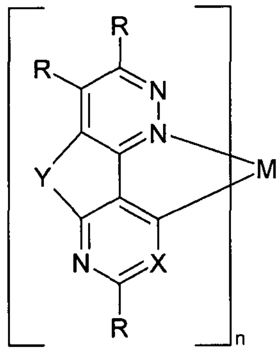

formule (10)

,

dans lesquelles les symboles et indices utilisés présentent les significations données selon la revendication 1.

**5.** Composé selon une ou plusieurs des revendications 1 à 4, **caractérisé en ce que** X représente CR et de façon préférable, représente CH.

**6.** Composé selon une ou plusieurs des revendications 1 à 5, **caractérisé en ce que** le substituant R à la position ortho sur la coordination métal représente un groupe qui est pareillement coordonné avec le métal M.

**7.** Composé selon une ou plusieurs des revendications 1 à 6, choisi parmi les composés des formules (19) et (20) qui suivent :

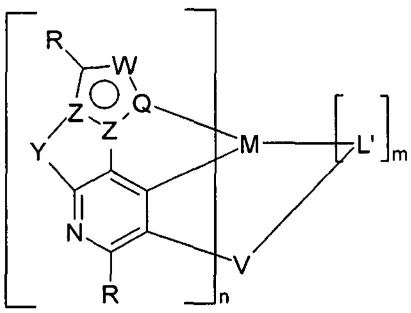

formule (19)

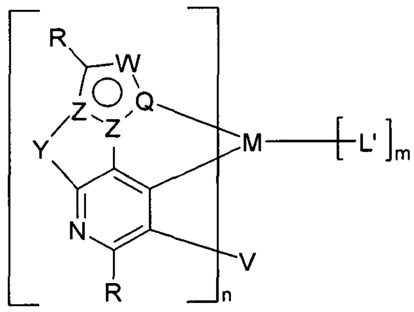

formule (20)

dans lesquelles les symboles utilisés présentent les significations données selon la revendication 1, où V représente une unité de pontage contenant 1 à 80 atome(s) pris parmi le troisième, le quatrième, le cinquième et/ou le sixième groupe principal ou un homocycle ou hétérocycle à 3 à 6 éléments qui lie de manière covalente les ligands partiels L les uns aux autres ou les ligands partiels L à L'.

**8.** Composé selon une ou plusieurs des revendications 1 à 7, **caractérisé en ce que** L' est choisi, de manière identique ou différente pour chaque occurrence, parmi le groupe constitué par le monoxyde de carbone, le monoxyde d'azote, les alkylcyanures, les arylcyanures, les alkylisocyanures, les arylisocyanures, les amines, les phosphines, les phosphites, les arsines, les stibines, les hétérocycles contenant de l'azote, les carbènes, l'hydrure, le deutérure, les halogénures $F^-$, $Cl^-$, $Br^-$ et $I^-$, les alkylacétylures, les arylacétylures, le cyanure, le cyanate, l'isocyanate, le thiocyanate, l'isothiocyanate, les alcoolates aliphatiques ou aromatiques, les thioalcoolates aliphatiques ou aromatiques, les amides, les carboxylates, les groupes aryle, $O^{2-}$, $S^{2-}$, les carbures, les nitrènes, $N^{3-}$, les diamines, les imines, les diimines, les diphosphines, les 1,3-dicétonates, les 3-cétonates, les salicyliminates, les dialcoolates, les dithiolates, les borates d'hétérocycles contenant de l'azote, $\eta^5$-cyclopentadiényle, $\eta^5$-pentaméthylcyclopentadiényle, $\eta^6$-benzène ou $\eta^7$-cycloheptatriényle, dont chacun peut être substitué par un radical ou des radicaux R, ou des ligands qui ont avec le métal un cycle à cinq éléments ou un cycle à six éléments cyclométallaté comportant au moins une liaison métal-carbone.

**9.** Procédé pour la préparation d'un composé selon une ou plusieurs des revendications 1 à 8 par réaction du ligand

avec des alcoxydes de métaux de la formule (64), avec des cétocétonates de métaux de la formule (65), avec des halogénures de métaux de la formule (66) ou avec des complexes de métaux dimériques de la formule (67) :

$M(OR)_n$

formule (64)

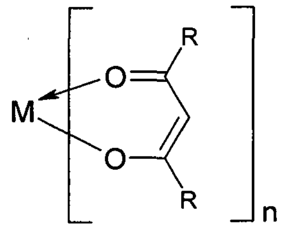

formule (65)

$MHal_n$

formule (66)

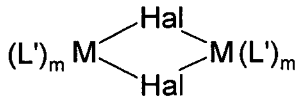

formule (67)

dans lesquelles les symboles M, m, n and R présentent les significations indiquées selon la revendication 1 et Hal = F, Cl, Br ou I.

**10.** Formulation, en particulier une solution, une dispersion ou une mini-émulsion, comprenant au moins un composé selon une ou plusieurs des revendications 1 à 8 et au moins un solvant.

**11.** Utilisation d'un composé selon une ou plusieurs des revendications 1 à 8 dans un dispositif électronique.

**12.** Dispositif électronique, en particulier choisi parmi le groupe constitué par les dispositifs électroluminescents organiques, les transistors à émission de lumière organiques, les cellules électrochimiques à émission de lumière organiques, les transistors électrochimiques à émission de lumière organiques, les circuits intégrés organiques, les transistors à effet de champ organiques, les transistors à film mince organiques, les cellules solaires organiques, les détecteurs optiques organiques, les photorécepteurs organiques, les dispositifs à extinction de champ organiques, les dispositifs à émission de plasmons organiques ou les diodes laser organiques, comprenant au moins un composé selon une ou plusieurs des revendications 1 à 8 dans au moins une couche.

**13.** Dispositif électronique selon la revendication 12, lequel est un dispositif électroluminescent organique ou une cellule électrochimique à émission de lumière organique, comprenant le composé selon une ou plusieurs des revendications 1 à 8 en tant que composé d'émission dans une ou plusieurs couche(s) d'émission.

**14.** Composé selon une ou plusieurs des revendications 1 à 8 ou formulation selon la revendication 10 ou dispositif selon la revendication 12 ou 13 pour la thérapie, en particulier la photothérapie, la prophylaxie et/ou le diagnostic de maladies et/ou de conditions cosmétiques.

Figur 1

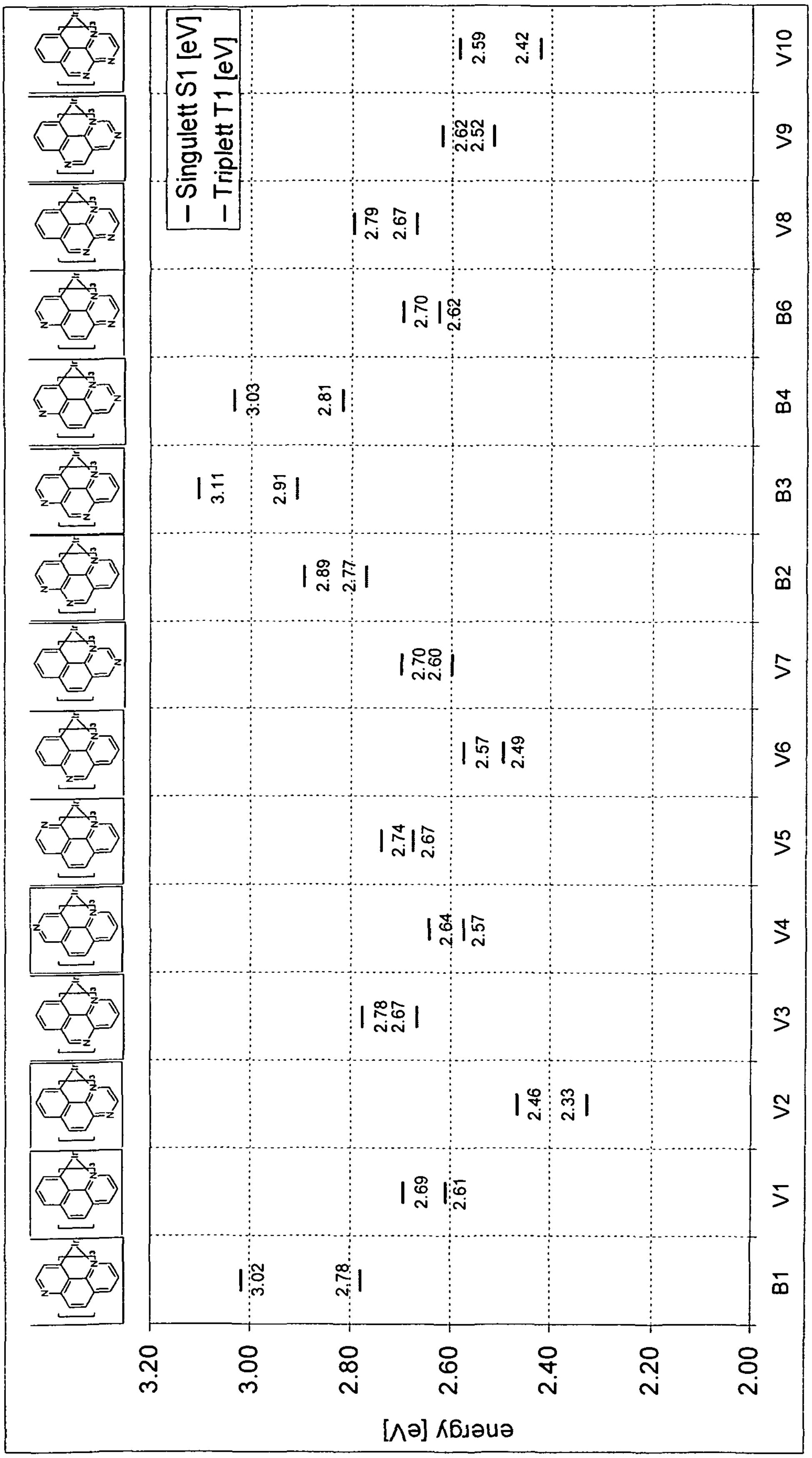
Singulett S1 [eV]
Triplett T1 [eV]
energy [eV]
3.20
3.00
2.80
2.60
2.40
2.20
2.00
B1 3.02 2.78
V1 2.69 2.61
V2 2.46 2.33
V3 2.78 2.67
V4 2.64 2.57
V5 2.74 2.67
V6 2.57 2.49
V7 2.70 2.60
B2 2.89 2.77
B3 3.11 2.91
B4 3.03 2.81
B6 2.70 2.62
V8 2.79 2.67
V9 2.62 2.52
V10 2.59 2.42

Figur 2

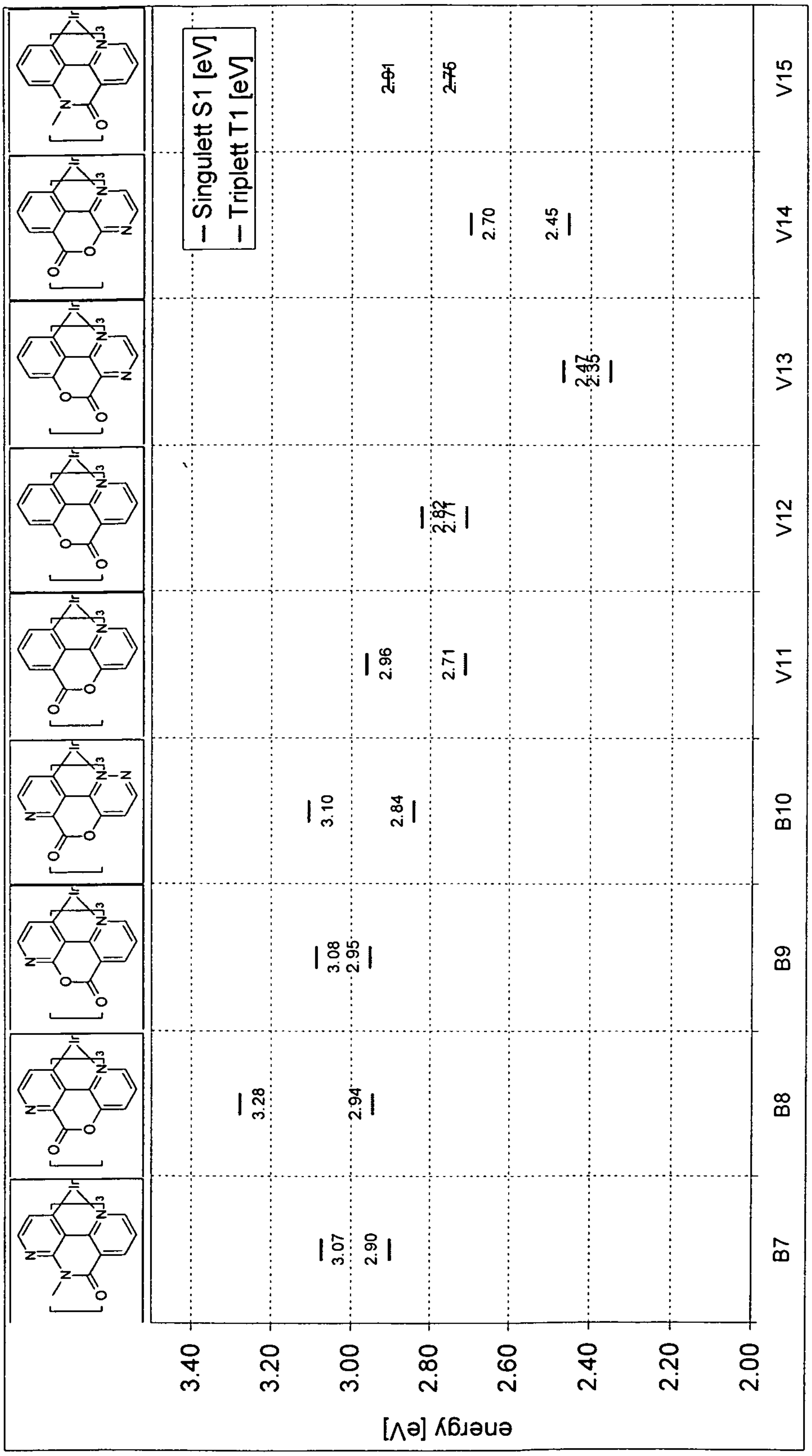

energy [eV]
3.40
3.20
3.00
2.80
2.60
2.40
2.20
2.00
— Singulett S1 [eV]
— Triplett T1 [eV]
B7
3.07
2.90
B8
3.28
2.94
B9
3.08
2.95
B10
3.10
2.84
V11
2.96
2.71
V12
2.82
2.71
V13
2.47
2.35
V14
2.70
2.45
V15
2.91
2.76

Figur 3

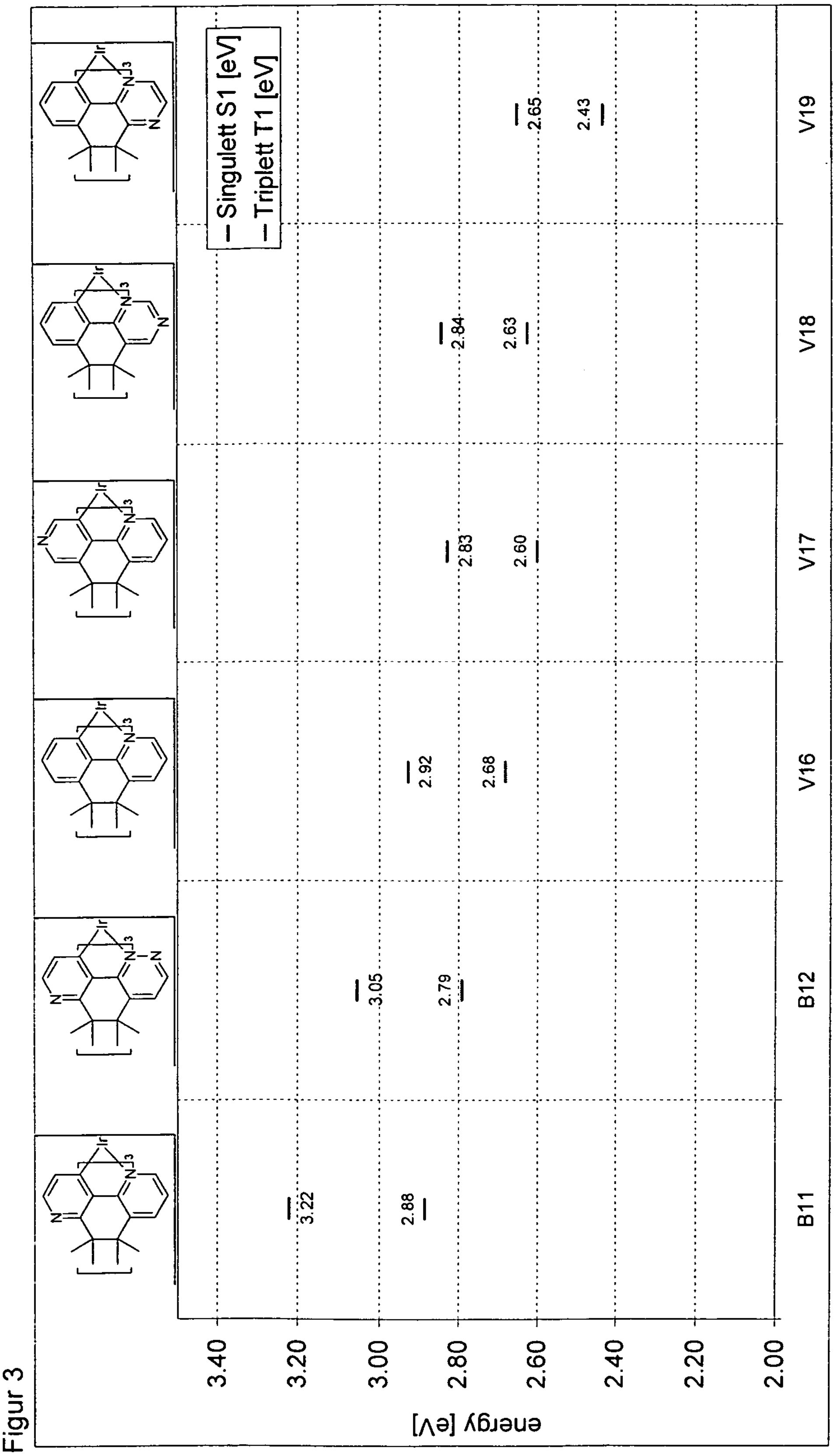

energy [eV]
3.40
3.20
3.00
2.80
2.60
2.40
2.20
2.00
Singulett S1 [eV]
Triplett T1 [eV]
3.22
2.88
3.05
2.79
2.92
2.68
2.83
2.60
2.84
2.63
2.65
2.43
B11
B12
V16
V17
V18
V19

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2007095118 A
- WO 0070655 A
- WO 2011024968 A
- WO 2011025068 A
- WO 2004085449 A
- WO 2002060910 A
- WO 2007065523 A
- WO 2005042548 A
- WO 2005011013 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- WO 2009148015 A
- US 20090136779 A
- WO 2010050778 A
- WO 2011042107 A
- WO 2011088877 A
- WO 2010108579 A
- WO 2005003253 A2
- WO 2009124627 A
- WO 2004058911 A


### In der Beschreibung aufgeführte Nicht-Patentliteratur


- **M. A. BALDO et al.** *Appl. Phys. Lett.,* 1999, vol. 75, 4-6
- **C. YUMUSAK.** *Appl. Phys. Lett.,* 2010, vol. 97, 03302
- **D. M. KOLLER et al.** *Nature Photonics,* 2008, vol. 2, 684
- **M. S. ARNOLD et al.** *Appl. Phys. Lett.,* 2008, vol. 92, 053301
- *Inorg. Chem.,* 2001, vol. 40, 1704